# EUROPEAN PATENT APPLICATION

(11) **EP 4 614 720 A1**
(43) Date of publication of application: **10.09.2025**
(21) Application number: 23885648.8
(22) Date of filing: 26.10.2023
(51) Int. Cl.: H01P 3/12, H05K 3/46

(54) **PRINTED WIRING BOARD AND METHOD FOR MANUFACTURING SAME**

(30) Priority: 31.10.2022 JP 2022174224
(71) Applicant: Kyocera Corporation, Kyoto-shi, Kyoto 612-8501 (JP)
(72) Inventor: FUKADA Susumu, Kyoto-shi, Kyoto 612-8501 (JP); KAWAGOE Atsuo, Kyoto-shi, Kyoto 612-8501 (JP)
(74) Representative: Viering, Jentschura & Partner mbB Patent- und Rechtsanwälte
(86) International application number: PCT/JP2023/038703
(87) International publication number: WO 2024/095892

(57) **Abstract**

A known problem is that signal waves transmitted by a post-type waveguide leak between adjacent via conductors. A printed wiring board 1 includes a dielectric layer 10, multiple inner conductors 22, and the multiple via conductors. The dielectric layer 10 includes first and second surfaces 10a and 10b facing away from each other and extending in surface directions, an inner dielectric portion 11 having a shape of a closed region extending in the surface directions, and an outer dielectric portion 12 located outside the inner dielectric portion 11 in the surface directions and surrounding the inner dielectric portion 11. The inner conductors 22 are formed on an outer peripheral surface 11a of the inner dielectric portion 11 and arranged with a gap between adjacent inner conductors 22 of the inner conductors 22 in a peripheral direction of the outer peripheral surface 11a on the outer peripheral surface 11a of the inner dielectric portion 11. The via conductors 28 are arranged between the outer peripheral surface 11a of the inner dielectric portion 11 and an inner peripheral surface 12a of the outer dielectric portion 12 at intervals in the peripheral direction, and each of the via conductors 28 is located between adjacent inner conductors 22 of the inner conductors 22 on the outer peripheral surface 11a of the inner dielectric portion 11 and connected to the adjacent inner conductors 22.

## Description

### TECHNICAL FIELD

The present disclosure relates to a printed wiring board and a method for manufacturing the printed wiring board.

### BACKGROUND OF INVENTION

Patent Literatures 1 and 2 disclose techniques in which a waveguide for transmitting radio-frequency signals such as microwave (including millimeter wave) is contained in a multilayer printed wiring board. The waveguides disclosed in Patent Literatures 1 and 2 extend in a surface direction orthogonal to the thickness direction of the printed wiring board and transmit radio-frequency signals in the surface direction.

Patent Literature 2 discloses a post-type waveguide in which multiple via conductors for interlayer connection, also referred to as so-called via posts, are arranged at intervals in surface directions (see paragraphs 0003 to 0006).

### CITATION LIST

### PATENT LITERATURE

Patent Literature 1: Japanese Unexamined Patent Application Publication No. H11-97854
Patent Literature 2: Japanese Unexamined Patent Application Publication No. 2001-16007

### SUMMARY

### PROBLEM TO BE SOLVED

In Patent Literature 1, a dielectric different from an insulating layer is embedded in the waveguide extending in a surface direction orthogonal to the thickness direction, and hence, the insulating layer and the dielectric have different dielectric properties. In addition, the dielectric to be embedded in the waveguide has physical properties prioritized for embedding, and hence, there is a problem in that a dielectric having a low dielectric constant and a low dielectric loss tangent required for the waveguide is unavailable.

Patent Literature 2 has a problem in that signal waves transmitted by the post-type waveguide leak between adjacent via conductors.

### SOLUTION TO PROBLEM

An aspect of the present disclosure is
a printed wiring board including:
   a dielectric layer;
   multiple inner conductors; and
   multiple via conductors, in which
the dielectric layer
   includes first and second surfaces facing away from each other and extending in surface directions,
   includes an inner dielectric portion having a shape of a closed region extending in the surface directions, and
   includes an outer dielectric portion located outside the inner dielectric portion in the surface directions and surrounding the inner dielectric portion,
the multiple inner conductors are formed on an outer periphery of the inner dielectric portion and arranged with a gap between adjacent inner conductors of the multiple inner conductors in a peripheral direction of the outer periphery on the outer periphery of the inner dielectric portion,
the via conductors are arranged between the outer periphery of the inner dielectric portion and an inner periphery of the outer dielectric portion at intervals in the peripheral direction, and
each of the via conductors is located between adjacent inner conductors of the inner conductors on the outer periphery of the inner dielectric portion and connected to the adjacent inner conductors.

An aspect of the present disclosure is
a method for manufacturing a printed wiring board, including:
forming multiple slots in a dielectric layer including first and second surfaces facing away from each other and extending in surface directions, the multiple slots surrounding a closed region, extending in the surface directions, of the dielectric layer and extending through the dielectric layer from the first surface to the second surface around the closed region;
forming metal plating layers on inner surfaces of the slots;
filling spaces on inner sides of the metal plating layers in the slots with resin, and curing the resin;
forming holes extending from the first surface to the second surface, each hole located in a portion between adjacent slots of the slots in the dielectric layer; and
forming via conductors on inner surfaces of the holes and electrically connecting the via conductors to the metal plating layers.

### ADVANTAGEOUS EFFECT

In the present disclosure, signal waves propagating from the first surface to the second surface or in the opposite direction in the inner dielectric portion do not leak to the outer dielectric portion.

### BRIEF DESCRIPTION OF THE DRAWINGS

FIG. 1 illustrates a printed wiring board in a first embodiment.
FIG. 2 illustrates an upper surface of the printed wiring board.
FIG. 3 is a cross-sectional view taken along line III-III in FIG. 2.
FIG. 4 is a cross-sectional view taken along line IV-IV in FIG. 2.
FIG. 5 is a cross-sectional view taken along line V-V in FIG. 4.
FIG. 6A illustrates a multilayer body in a step of manufacturing the printed wiring board.
FIG. 6B is an enlarged cross-sectional view of a multilayer body in a step of manufacturing the printed wiring board.
FIG. 7A illustrates a multilayer body in a step succeeding the step in FIG. 6A.
FIG. 7B is an enlarged cross-sectional view of a multilayer body in a step succeeding the step in FIG. 6B.
FIG. 8A illustrates a multilayer body in a step succeeding the step in FIG. 7A.
FIG. 8B is an enlarged cross-sectional view of a multilayer body in a step succeeding the step in FIG. 7B.
FIG. 9A illustrates a multilayer body in a step succeeding the step in FIG. 8A.
FIG. 9B is an enlarged cross-sectional view of a multilayer body in a step succeeding the step in FIG. 8B.
FIG. 10A illustrates a multilayer body in a step succeeding the step in FIG. 9A.
FIG. 10B is an enlarged cross-sectional view of a multilayer body in a step succeeding the step in FIG. 9B.
FIG. 11A illustrates a multilayer body in a step succeeding the step in FIG. 10A.
FIG. 11B is an enlarged cross-sectional view of a multilayer body in a step succeeding the step in FIG. 10B.
FIG. 12 is an enlarged cross-sectional view of a printed wiring board in a variation.
FIG. 13 is an enlarged cross-sectional view of a printed wiring board in a variation.
FIG. 14 is an enlarged cross-sectional view of a printed wiring board in a variation.
FIG. 15 is an enlarged cross-sectional view of a printed wiring board in a variation.
FIG. 16 is an enlarged cross-sectional view of a printed wiring board in a variation.
FIG. 17 is an enlarged cross-sectional view of a printed wiring board in a variation.
FIG. 18 is an enlarged cross-sectional view of a printed wiring board in a variation.
FIG. 19 illustrates a printed wiring board in a second embodiment.
FIG. 20 illustrates an upper surface of the printed wiring board in the second embodiment.
FIG. 21 is a cross-sectional view taken along line XXI-XXI in FIG. 20.
FIG. 22 is a cross-sectional view taken along line XXII-XXII in FIG. 20.
FIG. 23 is a cross-sectional view taken along line XXIII-XXIII in FIG. 20.
FIG. 24 is a cross-sectional view of a multilayer body in a step of manufacturing the printed wiring board.
FIG. 25 is a cross-sectional view of a multilayer body in a step succeeding the step in FIG. 24.
FIG. 26 is a cross-sectional view of a multilayer body in a step succeeding the step in FIG. 25.
FIG. 27 illustrates an upper surface of a printed wiring board in a third embodiment.
FIG. 28 is a cross-sectional view taken along line XXVIII-XXVIII in FIG. 27.
FIG. 29 is a cross-sectional view taken along line XXIX-XXIX in FIG. 27.
FIG. 30A is a cross-sectional view of a multilayer body in a step of manufacturing the printed wiring board.
FIG. 30B is a cross-sectional view of a multilayer body in a step of manufacturing the printed wiring board.
FIG. 31A is a cross-sectional view of a multilayer body in a step succeeding the step in FIG. 30A.
FIG. 31B is a cross-sectional view of a multilayer body in a step succeeding the step in FIG. 30B.
FIG. 32A is a cross-sectional view of a multilayer body in a step succeeding the step in FIG. 31A.
FIG. 32B is a cross-sectional view of a multilayer body in a step succeeding the step in FIG. 31B.
FIG. 33A is a cross-sectional view of a multilayer body in a step succeeding the step in FIG. 32A.
FIG. 34A is a cross-sectional view of a multilayer body in a step succeeding the step in FIG. 33A.
FIG. 35A is a cross-sectional view of a multilayer body in a step succeeding the step in FIG. 34A.
FIG. 36B is a cross-sectional view of a multilayer body in a step succeeding the step in FIG. 35A.
FIG. 37A is a cross-sectional view of a multilayer body in a step succeeding the step in FIG. 36B.
FIG. 37B is a cross-sectional view of a multilayer body in a step succeeding the step in FIG. 36B.

### DESCRIPTION OF EMBODIMENTS

Hereinafter, embodiments will be described with reference to the drawings. Each figure referred to in the following description schematically illustrates only main members necessary to explain the embodiments, for convenience of explanation. Hence, printed wiring boards 1, 100, and 200 in the present disclosure may include any components not illustrated in the drawings. The dimensions of the members in the drawings are not consistent with the dimensions, dimensional ratios, and the like of actual components.

### <<First Embodiment>>

### [1. Printed Wiring Board]

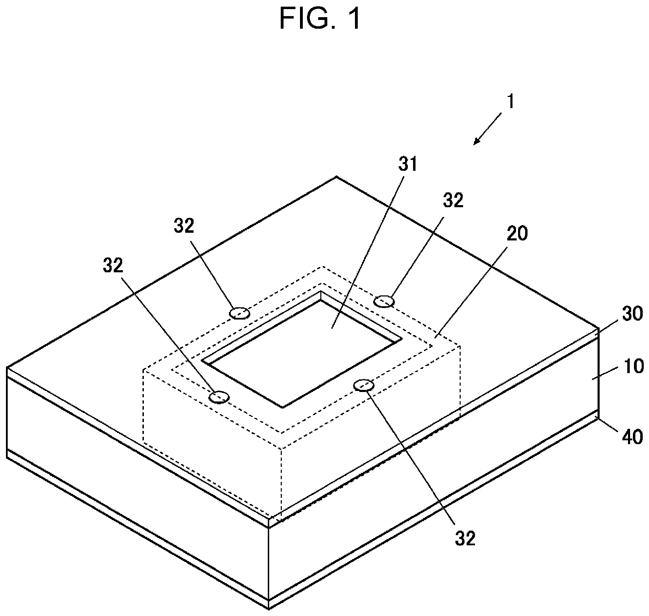

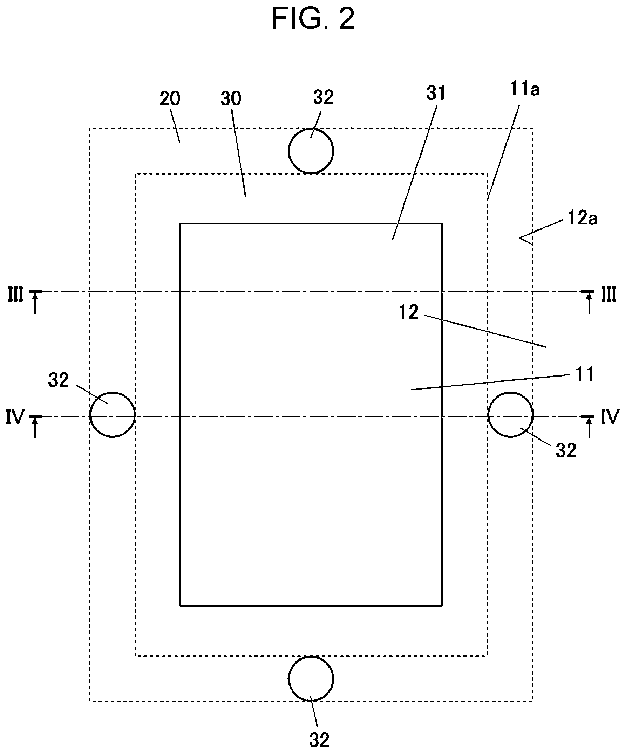

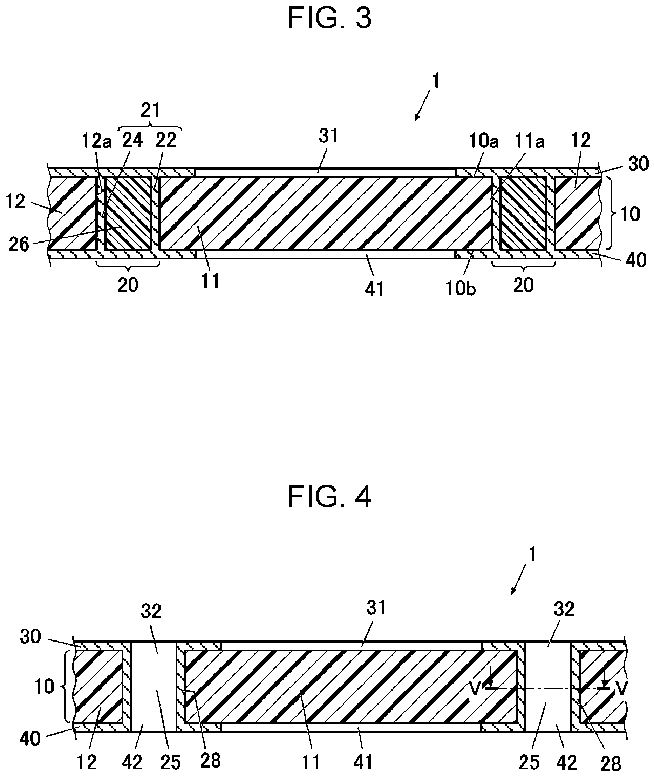

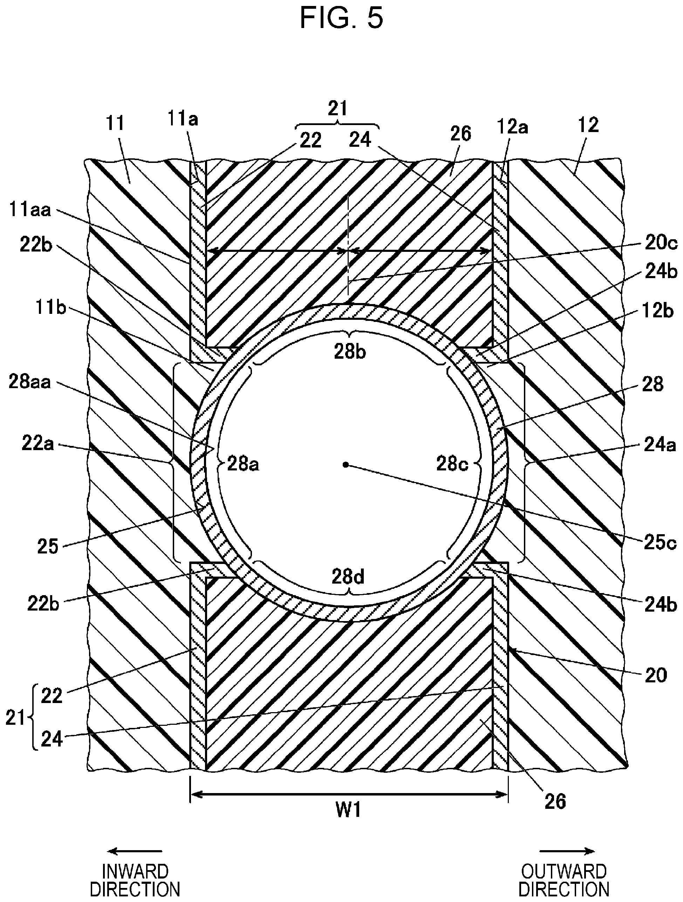

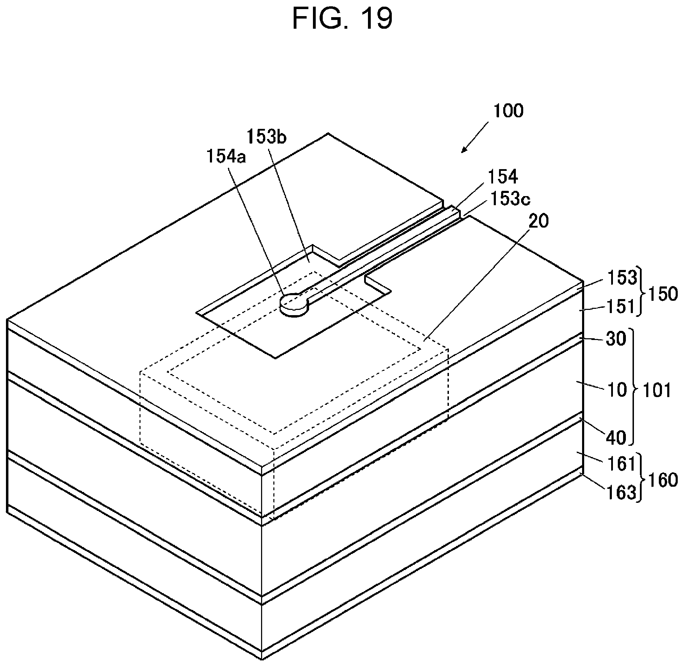

A printed wiring board 1 will be described with reference to FIGs. 1 to 5. FIG. 1 is a perspective view of the printed wiring board 1. FIG. 2 is a plan view of the printed wiring board 1. FIG. 3 is a cross-sectional view taken along line III-III in FIG. 2. FIG. 4 is a cross-sectional view taken along line IV-IV in FIG. 2. FIG. 5 is a cross-sectional view taken along line V-V in FIG. 4. FIG. 1 illustrates part of the printed wiring board 1, which extends in a range larger than the range illustrated in FIG. 1. In the following, a so-called double-sided board illustrated in FIG. 1 may be referred to as a core board when it needs to be distinguished from a printed wiring board illustrated in FIG. 19.

The printed wiring board 1 is a board including a waveguide. The printed wiring board 1 includes a dielectric layer 10, a perimeter portion 20, and conductor layers 30 and 40. The waveguide is composed of the perimeter portion 20 and the portion inside the perimeter portion 20.

Note that the printed wiring board 1 may be used as a core board for a build-up printed wiring board 100. The use of the printed wiring board 1 as a core board will be described in detail later.

The dielectric layer 10 is a core material having a flat plate shape. As illustrated in FIG. 3, the dielectric layer 10 includes a first surface 10a and a second surface 10b on the side opposite to the first surface 10a. The first surface 10a and the second surface 10b face away from each other. The dielectric layer 10 has a thickness from the first surface 10a to the second surface 10b. The thickness of the dielectric layer 10 is, for example, 1.0 mm. Hereinafter, the thickness direction means the direction from the first surface 10a toward the second surface 10b and the direction opposite to it. Surface directions mean directions along the first surface 10a or the second surface 10b.

The dielectric layer 10 is composed of a material having dielectric properties. Examples of such materials having dielectric properties include organic resins such as liquid crystal polymer, epoxy resin, bismaleimide-triazine resin, polyimide resin, polyphenylene ether (PPE) resin, polyphenylene oxide (PPO) resin, and cyanate ester resin. Two or more of these organic resins may be mixed. One or two or more of these organic resins may be blended with a reinforcement material. Examples of reinforcement materials include glass fibers, glass nonwoven fabrics, aramid fibers, aramid nonwoven fabrics, polyester fibers, and polyester nonwoven fabrics. One or two or more of these organic resins may contain inorganic fillers such as barium sulfate, talc, clay, glass, calcium carbonate, and titanium, for example.

As illustrated in FIGs. 2 and 3, the dielectric layer 10 includes an inner dielectric portion 11 and an outer dielectric portion 12.

The inner dielectric portion 11 is in a shape of a closed region extending in surface directions, specifically, extending in a rectangular shape. The meaning of a rectangle mentioned here includes a square. However, the inner dielectric portion 11 may extend in a circular shape, an elliptical shape, or the like.

The outer dielectric portion 12 is the region located outside the inner dielectric portion 11 in surface directions, surrounds the inner dielectric portion 11, and extending in surface directions. The inner dielectric portion 11 and the outer dielectric portion 12 are initially formed as an integrated structure, but they are separated by the perimeter portion 20, described later, in a frame shape surrounding the inner dielectric portion 11. Since the inner dielectric portion 11 and the outer dielectric portion 12 undergo the same steps and are cured and formed at the same time, the inner dielectric portion 11 and the outer dielectric portion 12 have the same dielectric properties. Materials having planar shapes with a low dielectric constant and a low dielectric loss tangent suitable for the dielectric layer 10 are commercially available, and hence, it is easy to form the inner dielectric portion having a low dielectric constant and a low dielectric loss tangent, required for a waveguide .

As illustrated in FIG. 5, the inner dielectric portion 11 includes multiple dielectric protrusions 11b arranged on an outer peripheral surface 11a of the inner dielectric portion 11 at intervals in the peripheral direction of the outer peripheral surface 11a. The outer dielectric portion 12 includes multiple dielectric protrusions 12b arranged on an inner peripheral surface 12a of the outer dielectric portion 12 at intervals in the peripheral direction of the inner peripheral surface 12a.

In the inner dielectric portion 11, signal waves propagate in the thickness direction, and the leakage of signal waves from the inner dielectric portion 11 to the outer dielectric portion 12 is suppressed by the perimeter portion 20. The signal waves are at radio frequencies, for example, microwaves (including millimeter waves). Microwaves mean radio waves with a frequency of 300 MHz to 3 THz and a wavelength of 1 m to 0.1 mm. In particular, millimeter waves mean radio waves with a frequency of 30 GHz to 300 GHz and a wavelength of 10 mm to 1 mm.

As illustrated in FIGs. 2 and 5, the perimeter portion 20 is located between the outer peripheral surface 11a of the inner dielectric portion 11 and the inner peripheral surface 12a of the outer dielectric portion 12. The width W1 of the perimeter portion 20, in other words, the width W1 from the outer peripheral surface 11a of the inner dielectric portion 11 to the inner peripheral surface 12a of the outer dielectric portion 12 is, for example, 500 µm. In this case, it is preferable that the perimeter portion 20 include multiple enclosure conductors 21, multiple pieces of filling resin 26, and multiple via conductors 28.

As illustrated in FIGs. 2 and 5, the multiple enclosure conductors 21 are arranged on the outer peripheral surface 11a of the inner dielectric portion 11 and the inner peripheral surface 12a of the outer dielectric portion 12 in the peripheral direction with a gap between adjacent enclosure conductors 21 and surround the inner dielectric portion 11. In this case, as illustrated in FIG. 3, the enclosure conductors 21 are present throughout the entire thickness of the dielectric layer 10 from the first surface 10a to the second surface 10b. As illustrated in FIG. 4, each via conductor 28 is located between adjacent enclosure conductor 21 and present from the first surface 10a to the second surface 10b of the dielectric layer 10 and electrically connects adjacent enclosure conductors 21.

As illustrated in FIG. 5, each enclosure conductor 21 includes an inner conductor 22 and an outer conductor 24.

The inner conductors 22 are present on the outer peripheral surface 11a of the inner dielectric portion 11 throughout the entire thickness of the dielectric layer 10 from the first surface 10a to the second surface 10b. The inner conductors 22 are arranged in the peripheral direction of the outer peripheral surface 11a of the inner dielectric portion 11 with a gap 22a between adjacent inner conductors 22 in the peripheral direction. Hereinafter, the gap 22a between adjacent inner conductors 22 is referred to as the discontinued portion 22a. The position of each discontinued portion 22a is the midpoint between adjacent corners of the outer peripheral surface 11a of the inner dielectric portion 11. However, the position may be deviated from the midpoint. The position of the discontinued portion 22a corresponds to the positions of the dielectric protrusions 11b, and the dielectric protrusions 11b are located in the discontinued portion 22a. Although adjacent inner conductors 2 are separated by the discontinued portion 22a, the via conductor 28, in the discontinued portion 22a, electrically connects the adjacent inner conductors 22 in the peripheral direction. Each inner conductor 22 includes a conductor protrusion 22b protruding in an outward direction at each edge of the inner conductor 22 forming the discontinued portion 22a. An outward direction means a direction from the inner conductor 22 toward the outer conductor 24.

The outer conductors 24 are present on the inner peripheral surface 12a of the outer dielectric portion 12 throughout the entire thickness of the dielectric layer 10 from the first surface 10a to the second surface 10b. The outer conductors 24 are located away from the inner conductors 22 in outward directions. The outer conductors 24 are arranged in the peripheral direction of an inner peripheral surface 12a of the outer dielectric portion 12 with a gap 24a between adjacent outer conductors 24 in the peripheral direction. Hereinafter, the gap 24a between adjacent outer conductors 24 is referred to as the discontinued portion 24a. The position of each discontinued portion 24a is the midpoint between adjacent corners of the inner peripheral surface 12a of the outer dielectric portion 12. However, the position may be deviated from the midpoint. The position of the discontinued portion 24a corresponds to the positions of the dielectric protrusions 12b, and the dielectric protrusions 12b are located in the discontinued portion 24a. Although adjacent outer conductors 24 are separated by the discontinued portion 24a, the via conductor 28, in the discontinued portion 24a, electrically connects the adjacent outer conductors 24 in the peripheral direction. Each outer conductor 24 includes a conductor protrusion 24b protruding in an inward direction at each edge of the outer conductor 24 forming the discontinued portion 24a. An inward direction means a direction from the outer conductor 24 toward the inner conductor 22.

The discontinued portion 24a of the outer conductors 24 and the discontinued portion 22a of the inner conductors 22 face each other in an inward-outward direction, and the position of the discontinued portion 24a in the peripheral direction and the position of the discontinued portion 22a in the peripheral direction are aligned with each other. An inward-outward direction means a direction from the outer conductor 24 toward the inner conductor 22 or the direction opposite to it.

As illustrated in FIGs. 3 and 5, each piece of filling resin 26 is located between the corresponding inner conductor 22 and outer conductor 24. The pieces of filling resin 26 are arranged in the peripheral direction of the outer peripheral surface 11a of the inner dielectric portion 11with a gap between adjacent pieces of filling resin 26 in the peripheral direction. In the space between adjacent pieces of filling resin 26 is a circular hole 25 extending through the dielectric layer 10 from the first surface 10a to the second surface 10b. Adjacent pieces of filling resin 26 and the dielectric protrusions 11b and 12b of the inner dielectric portion 11 and the outer dielectric portion 12 form the hole 25. The hole 25 is also referred to as the via.

In the expression "the hole 25 is circular", "being circular" mentioned here includes not only perfect circles but also shapes similar to perfect circles. Hence, the hole 25 may have a circular shape based on a perfect circle and having irregularities.

It is preferable that the diameter of the hole 25 be equal to the width W1 from the outer peripheral surface 11a of the inner dielectric portion 11 to the inner periphery of the outer dielectric portion 12. The expression "being equal" mentioned here includes not only "being exactly equal" but also "being approximately equal and close".

It is preferable that the center axis 25c of the hole 25 be positioned on an intermediate plane 20c of the perimeter portion 20. The intermediate plane 20c of the perimeter portion 20 means a plane passing the midpoints between the outer peripheral surface 11a of the inner dielectric portion 11 and the inner peripheral surface 12a of the outer dielectric portion 12 and parallel to the direction along the outer peripheral surface 11a and the inner peripheral surface 12a.

Since the diameter of the hole 25 is equal to the width W1, and the center axis 25c of the hole 25 is positioned on the intermediate plane of the perimeter portion 20, the via conductor 28 does not protrude from the outer peripheral surface 11a of the inner dielectric portion 11 toward the center of the inner dielectric portion 11. In addition, the via conductor 28 does not protrude outward from the inner peripheral surface 12a of the outer dielectric portion 12.

The filling resin 26 is composed of a material having dielectric properties. Example of such materials having dielectric properties include organic resins such as liquid crystal polymer, epoxy resin, bismaleimide-triazine resin, polyimide resin, polyphenylene ether (PPE) resin, polyphenylene oxide (PPO) resin, and cyanate ester resin. Two or more of these organic resins may be mixed. One or two or more of these organic resins may be blended with a reinforcement material. Examples of the reinforcement material include inorganic fillers such as barium sulfate, talc, clay, glass, calcium carbonate, and titanium. The material of the filling resin 26 and the material of the inner dielectric portion 11 and the outer dielectric portion 12 may be the same or different.

The via conductor 28 is located along the inner side of the hole 25. More specifically, the via conductor 28 is present on the inner wall surface of the hole 25 throughout the entire thickness of the dielectric layer 10 from the first surface 10a to the second surface 10b. The via conductor 28 is composed of metal plating, for example, copper plating. Since the hole 25 is circular in plan view, the via conductor 28 is cylindrical.

The via conductor 28 is electrically connected to the inner conductors 22 and the outer conductors 24. Specifically, the via conductor 28 is electrically connected to the conductor protrusions 22b of the inner conductors 22 at both ends of the discontinued portion 22a and also electrically connected to the conductor protrusions 24b of the outer conductors 24 at both ends of the discontinued portion 24a.

The via conductor 28 includes four conductive portions 28a to 28d located side by side in the circumferential direction of the hole 25. The conductive portion 28a is located along the dielectric protrusions 11b of the inner dielectric portion 11 so as to span the discontinued portion 22a between adjacent inner conductors 22. The conductive portion 28a electrically connects the inner conductors 22 at both ends of the discontinued portion 22a. The conductive portion 28c is located on the opposite side of the center axis of the hole 25 from the conductive portion 28a. The conductive portion 28c is located along the dielectric protrusions 12b of the outer dielectric portion 12 so as to span the discontinued portion 24a between adjacent outer conductors 24. The conductive portion 28c electrically connects the outer conductors 24 at both ends of the discontinued portion 24a. The conductive portions 28a and 28c are composed of a metal (in particular, copper) having a higher Young's modulus and a lower thermal expansion coefficient than resins, and hence the conductive portions 28a and 28c contribute to improving the strength of the perimeter portion 20 in the peripheral direction of the outer peripheral surface 11a of the inner dielectric portion 11 or the inner peripheral surface 12a of the outer dielectric portion 12. Each of the conductive portions 28b and 28d is formed on a wall surface of the corresponding piece of filling resin 26 in the hole 25 in the width direction from the outer peripheral surface 11a of the inner dielectric portion 11 toward the inner peripheral surface 12a of the outer dielectric portion 12. The conductive portions 28b and 28d are located between the conductive portion 28a and the conductive portion 28c. The conductive portions 28b and 28d electrically connect the inner conductors 22 and the outer conductors 24. The conductive portions 28b and 28d are composed of a metal (in particular, copper) having a higher Young's modulus and a lower thermal expansion coefficient than resins, and hence the conductive portions 28b and 28d contribute to improving the strength of the perimeter portion 20 in the width direction. In this case, it is preferable that the portion (denoted by the symbol 28aa in FIG. 5) of the conductive portion 28a in the via conductor 28 closest to the center of the inner dielectric portion 11 be closer to the plane formed by extending the inner conductors 22. This configuration enables the reflection of radio waves to be reduced in the region connecting the inner conductors 22 and the via conductor 28, improving the characteristics of the waveguide formed in an inner region of the inner conductor 22. The plane formed by extending the inner conductors 22 corresponds to the plane 11aa formed by extending the outer peripheral surface 11a of the inner dielectric portion 11 in the direction along the outer peripheral surface 11a.

As illustrated in FIG. 1, the conductor layer 30 is located on the first surface 10a of the dielectric layer 10. In this case, as illustrated in FIG. 3, the conductor layer 30 covers not only the first surface 10a of the dielectric layer 10 but also the filling resin 26. The conductor layer 40 is located on the second surface 10b of the dielectric layer 10. The conductor layer 40 covers not only the second surface 10b of the dielectric layer 10 but also the filling resin 26. The material of the conductor layers 30 and 40 is a conductive metal, for example, copper. The conductor layers 30 and 40 are electrically connected to the inner conductors 22, the outer conductors 24, and the via conductors 28. The conductor layers 30 and 40 are ground conductors, and the inner conductors 22, the outer conductors 24, and the via conductors 28 also are ground conductors.

The conductor layer 30 includes a rectangular port 31 that is open at a position overlapping the inner dielectric portion 11. The port 31 and the inner dielectric portion 11 have the same center, and the edge of the port 31 is located inside the outer peripheral surface 11a of the inner dielectric portion 11. Each of the four sides of the port 31 is parallel to the corresponding one of the four faces of the outer peripheral surface 11a of the inner dielectric portion 11. The size of the port 31 may be equal to or different from the size of a port 41 of the conductor layer 40. The conductor layer 30 includes openings 32 at the positions corresponding to the holes 25. Each opening 32 and the corresponding hole 25 are coaxial in the thickness direction.

The conductor layer 40 includes the port 41 which is rectangular and open at a position overlapping the inner dielectric portion 11. The port 41 and the inner dielectric portion 11 have the same center, and the edge of the port 41 is located inside the outer peripheral surface 11a of the inner dielectric portion 11. Each of the four sides of the port 41 is parallel to the corresponding one of the four faces of the outer peripheral surface 11a of the inner dielectric portion 11. The size of the port 41 may be equal to or different from the size of the port 31 of the conductor layer 30. The conductor layer 40 includes openings 42 at the positions corresponding to the holes 25. Each opening 42 and the corresponding hole 25 are coaxial in the thickness direction.

Note that wiring patterns may be formed in the conductor layers 30 and 40 outside the range illustrated in FIG. 1.

In the example illustrated in FIGs. 4 and 5, the inside of the via conductor 28 is hollow. Alternatively, the inside of the via conductors 28 may be filled with filling resin. In this case, the filling resin may be present throughout the entire thickness of the dielectric layer 10, and the conductor layer 30 may cover the filling resin in the via conductors 28. Similarly, the conductor layer 40 also may cover the filling resin in the via conductors 28.

In the example illustrated in FIG. 3, the conductor layer 30 covers the filling resin 26. Alternatively, a configuration in which the conductor layer 30 does not cover the filling resin 26, and the filling resin 26 is exposed is possible. Similarly, a configuration in which the conductor layer 40 does not cover the filling resin 26, and the filling resin 26 is exposed is also possible.

The perimeter portion 20 with the configuration described above and the inner dielectric portion 11 inside the perimeter portion 20 form a tubular waveguide configured to transmit signal waves, in other words, a waveguide . Signal waves are transmitted from the port 31 through the inner dielectric portion 11 to the port 41. Examples of signal waves include transverse electric (TE) waves and transverse magnetic (TM) waves. Since the discontinued portion 22a between adjacent inner conductors 22 is short-circuited by the via conductor 28, signal waves do not leak from the inner dielectric portion 11 through the discontinued portion 22a to the outer dielectric portion 12.

### [2. Method for Manufacturing Printed Wiring Board]

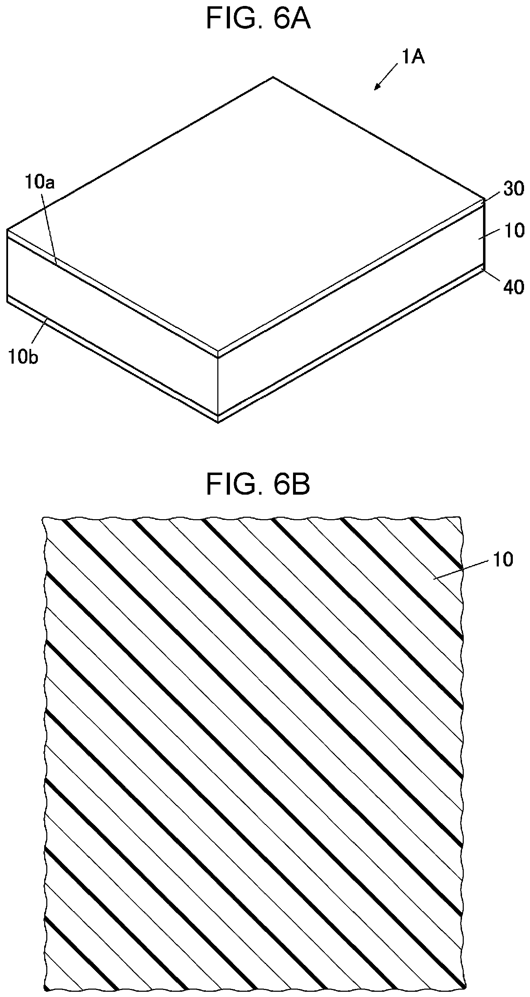

Next, a method for manufacturing the printed wiring board 1 according to the first embodiment will be described with reference to FIGs. 6A to 11A and FIGs. 6B to 11B. FIGs. 6A to 11A are perspective views of a multilayer body 1A that is used to form the printed wiring board 1. FIGs. 6B to 11B are cross-sectional views of the multilayer body 1A. The positions of the cross sections in FIGs. 6B to 11B are the same as the position of the cross section in FIG. 5.

### (1) Preparation

First, a multilayer body 1A is prepared as illustrated in FIGs. 6A and 6B. The multilayer body 1A includes the dielectric layer 10 and the conductor layers 30 and 40 stacked on the first surface 10a and the second surface 10b, respectively, of the dielectric layer 10. At this point, the dielectric layer 10 has not been separated into the inner dielectric portion 11 and the outer dielectric portion 12. The conductor layer 30 spreads entirely over the first surface 10a of the dielectric layer 10, and the port 31 and the opening 32 have not been formed in the conductor layer 30. Similarly, the conductor layer 40 also spreads entirely over the second surface 10b of the dielectric layer 10, and the port 41 and the opening 42 have not been formed in the conductor layer 40.

### (2) Formation of Slots

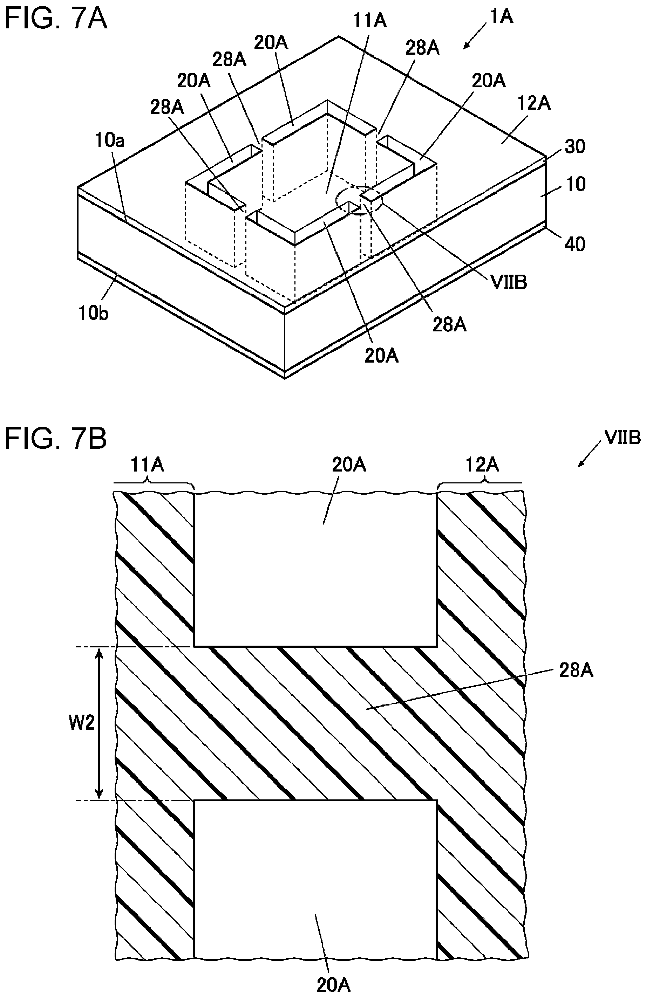

Next, as illustrated in FIGs. 7A and 7B, multiple slots 20A are formed in the multilayer body 1A. In this case, the multiple slots 20A are formed to surround a rectangular closed region 11A in the multilayer body 1A. The multiple slots 20A extend through the multilayer body 1A from the conductor layer 30 to the conductor layer 40, around the closed region 11A. The width W1 of the slots 20A corresponds to the distance from the outer peripheral surface 11a of the inner dielectric portion 11 to the inner peripheral surface 12a of the outer dielectric portion 12. The width W1 is, for example, 500 µm.

When these slots 20A are formed, a portion between adjacent slots 20A in the peripheral direction of the closed region 11A is left unprocessed such that a specified gap remains. In this case, a portion 28A (hereinafter referred to as a connection portion 28A) is present between two adjacent slots 20A. The connection portions 28A link the closed region 11A and the outer region 12A outside the closed region 11A. Hence, the closed region 11A does not fall off from the outer region 12A. It is preferable that the width W2 of the connection portion 28A be smaller than the diameter of the hole 25 to be formed later. It is preferable that each slot 20A have a shape including an L shape to form a corner of the closed region 11A. The slots 20A are formed by, for example, etching, laser-beam cutting, sand blast cutting, liquid jet cutting, or mechanical cutting. Examples of tools that are used in mechanical cutting include routers.

Note that desmearing may be performed to remove resin residues in the slots 20A.

### (3) Plating

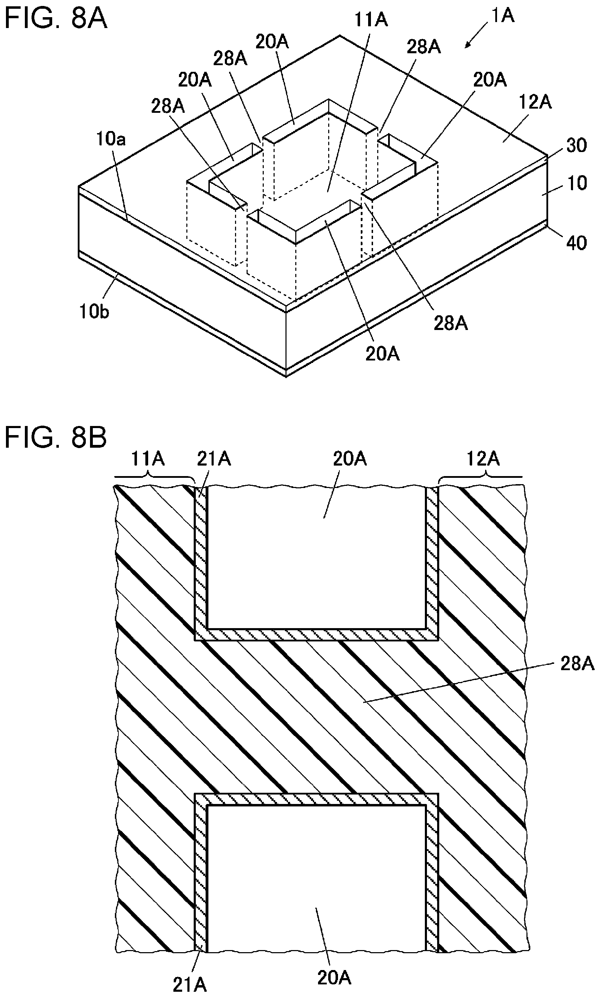

Next, as illustrated in FIGs. 8A and 8B, a plating process is performed on the multilayer body 1A in which the slots 20A are formed, so that a metal plating layer 21A is formed on the inner surface of each slot 20A. Such a plating process grows metal plating layers 21A also on the conductor layers 30 and 40, increasing their thickness. The metal plating layers 21A are used to form the inner conductors 22 and the outer conductors 24.

### (4) Resin Filling

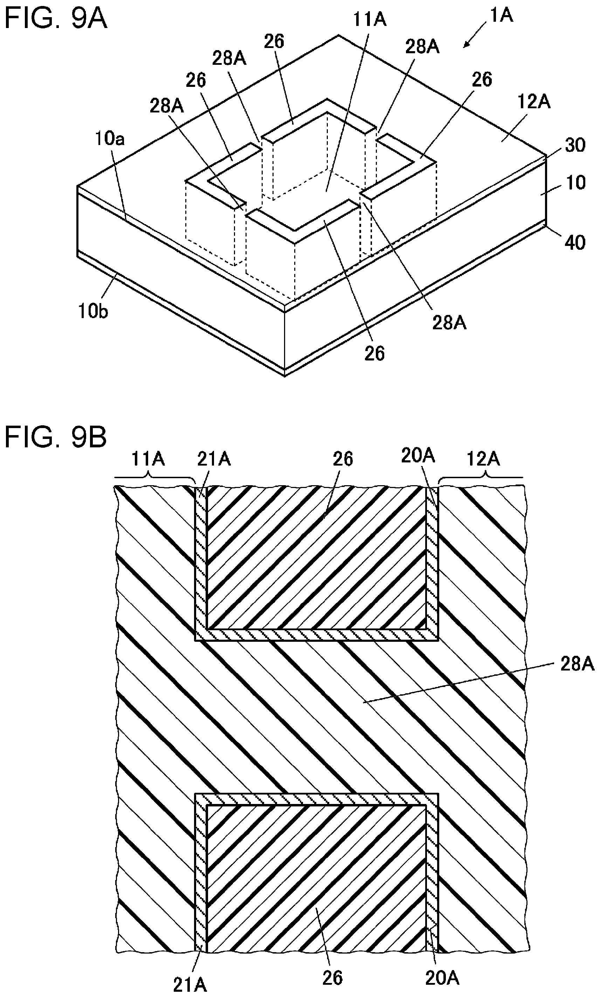

Next, as illustrated in FIGs. 9A and 9B, the space on the inner sides of each metal plating layer 21A is filled with resin, and the resin is cured. This process forms the filling resin 26. The inner sides of each metal plating layer 21A mean, of the surfaces (the main surfaces) of the metal plating layers 21A formed on the inner surfaces (the wall surfaces) of the slot 20A, the sides of the surfaces exposed and facing the sides opposite to the inner surfaces of the slot 20A.

### (5) Hole Formation

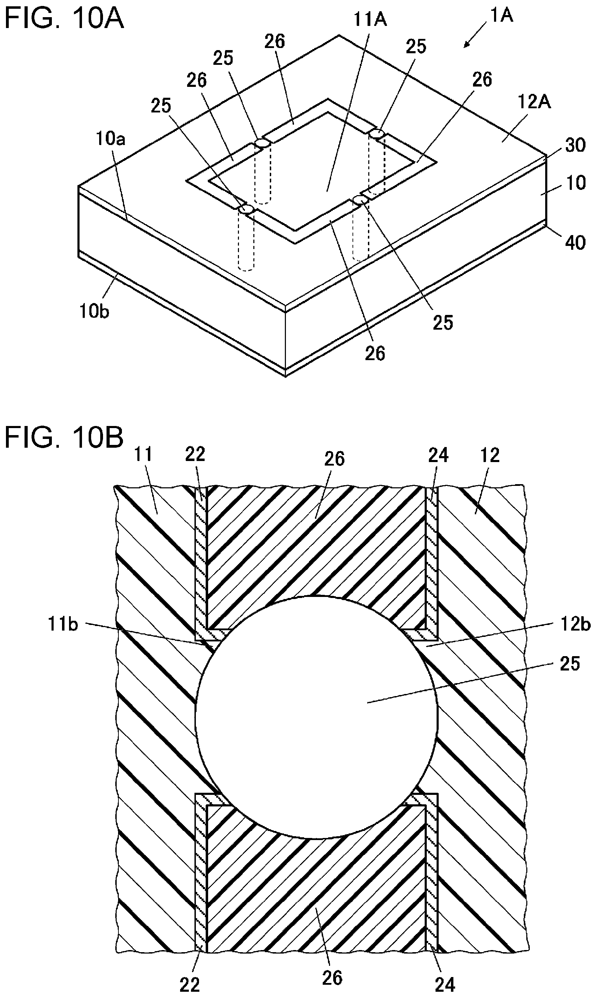

Next, as illustrated in FIGs. 10A and 10B, the holes 25 are formed in the connection portions 28A, so that the holes 25 extend from the conductor layer 30 through to the conductor layer 40. The diameter of the hole 25 needs only to be larger than the gap between adjacent slots 20A, in other words, the width W2 of the connection portion 28A (see FIG. 7B). The diameter of the hole 25 may be equal to the width of the slots 20A, in other words, the width W1 from the outer peripheral surface 11a of the inner dielectric portion 11 to the inner periphery of the outer dielectric portion 12 (see FIG. 5). The holes 25 may be formed by etching, laser beam drilling, sand blast drilling, liquid jet drilling, or mechanical drilling. Examples of tools that are used in mechanical drilling include drills. Forming the holes 25 at the portions serving as the connection portion 28A separates the dielectric layer 10 into the inner dielectric portion 11 and the outer dielectric portion 12. In this case, it is preferable that part of the dielectric layer 10 be left as the dielectric protrusions 11b and 12b at the positions where the connection portions 28A were located. Forming the holes 25 separates the metal plating layers 21A in the holes 25 into the inner conductors 22 and the outer conductors 24. In addition, forming the holes 25 partially removes the filling resin 26 from the slots 20A.

Note that desmearing may be performed to remove resin residues in the holes 25.

### (6) Plating

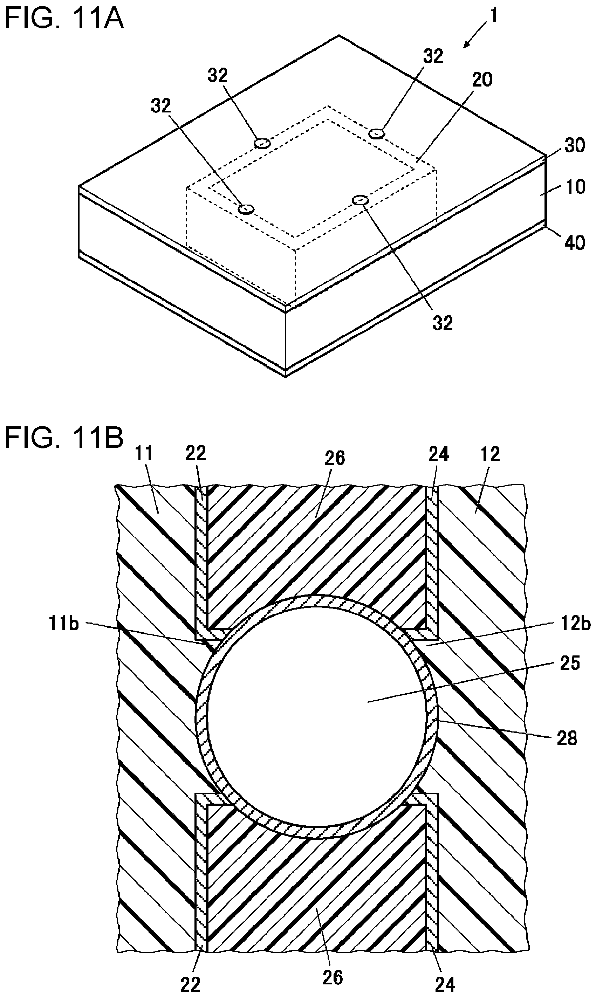

Next, as illustrated in FIGs. 11A and 11B, a plating process is performed on the multilayer body 1A with the formed holes 25 to form the via conductors 28 on the inner surfaces of the holes 25. Each via conductor 28 is electrically connected to the inner conductors 22 and the outer conductors 24. Plating films formed by the plating process as mentioned above are also formed on the conductor layers 30 and 40. Thus, the via conductors 28 are electrically connected to the conductor layers 30 and 40.

Note that after the via conductors 28 are formed, the insides of the via conductors 28 may be filled with resin, and the resin may be cured.

### (7) Formation of Ports

Next, the conductor layers 30 and 40 are covered with masks, and the regions of the conductor layers 30 and 40 corresponding to the inner dielectric portion 11 are removed by etching, so that the ports 31 and 41 are formed in the conductor layers 30 and 40, respectively (see FIGs. 1 and 3). When the ports 31 and 41 are formed, wiring patterns may be formed in regions of the conductor layers 30 and 40 away from the ports 31 and 41. In this case, the regions away from the ports 31 and 41 mean regions outside the range illustrated in FIG. 1.

Through the above processes, the printed wiring board 1 is completed.

### [3. Variations]

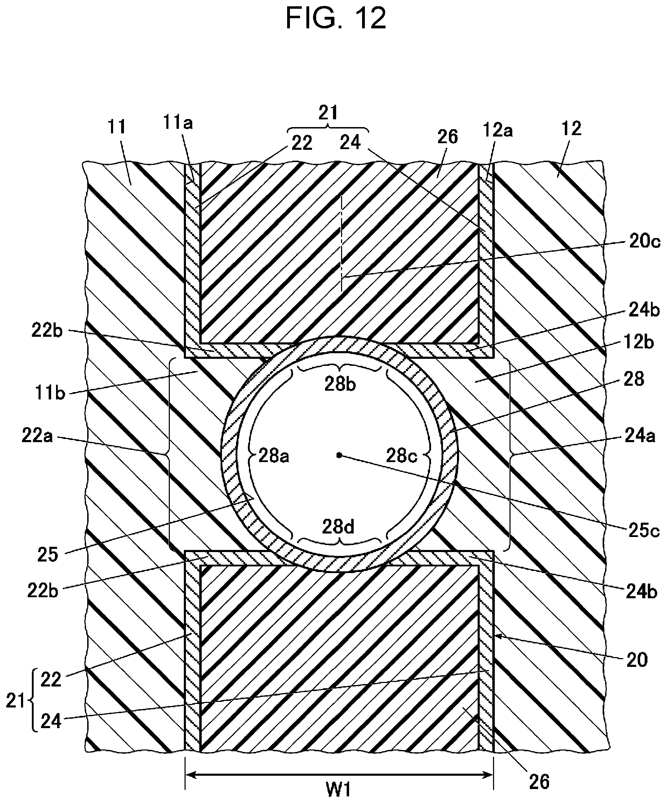

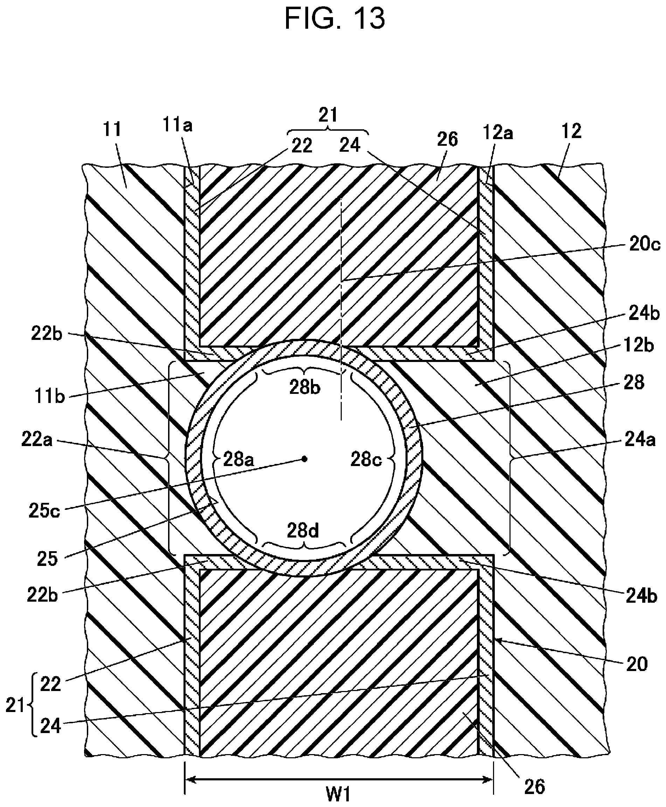

Variations obtained by changing the embodiment described above will be described. In the following, the points changed from the above embodiment will be described. Some of the changes described below may be combined and employed.
(1) In the above description, as illustrated in FIG. 5, the diameter of the hole 25 is equal to the width W1 from the outer peripheral surface 11a of the inner dielectric portion 11 to the inner periphery of the outer dielectric portion 12. Alternatively, the diameter of the hole 25 may be smaller than the width W1 as illustrated in FIGs. 12 and 13.

In the example illustrated in FIG. 12, the center axis 25c of the hole 25 is positioned on the intermediate plane 20c of the perimeter portion 20.

In the example illustrated in FIG. 13, the center axis 25c of the hole 25 is shifted from the intermediate plane 20c of the perimeter portion 20 toward the inner dielectric portion 11.

Although not illustrated, the center axis 25c of the hole 25 may be shifted from the intermediate plane 20c of the perimeter portion 20 toward the outer dielectric portion 12 by a limited distance.

In any case in FIG. 12, FIG. 13, and the case not illustrated, it is preferable that the via conductor 28 do not protrude from the outer peripheral surface 11a of the inner dielectric portion 11 toward the center of the inner dielectric portion 11. This is because the characteristics of the waveguide in the region inside the perimeter portion 20 can be higher when the via conductor 28 does not protrude toward the center of the inner dielectric portion 11. Specifically, the transmission loss of the waveguide can be lower. In this case, it is preferable that part of the inner wall of the hole 25 be in contact with the plane 11aa formed by extending the outer peripheral surface 11a of the inner dielectric portion 11 in the direction along the outer peripheral surface 11a. It is also preferable that via conductors 28 described later do not protrude outward from the inner peripheral surface 12a of the outer dielectric portion 12.

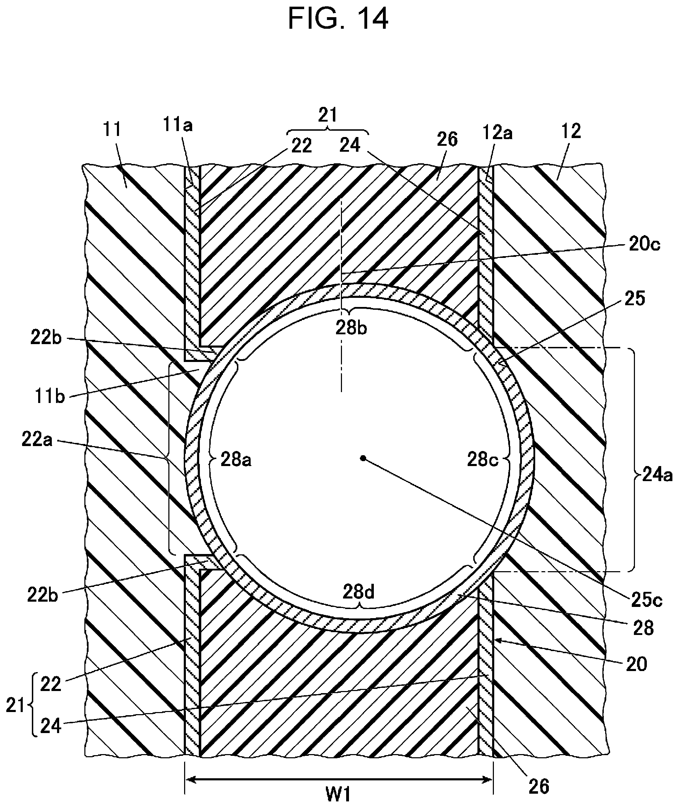

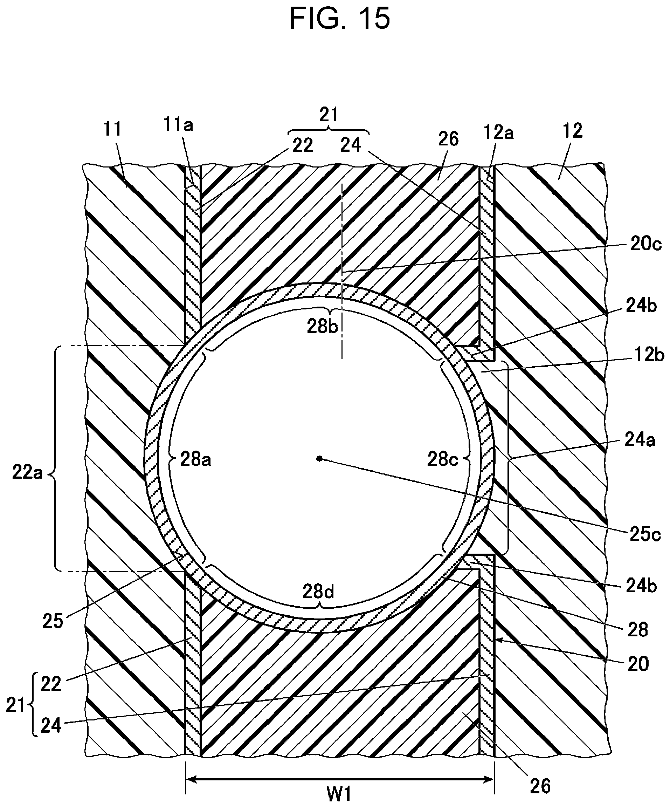

(2) The above description suggests that it is preferable that the diameter of the hole 25 be equal to the width W1 from the outer peripheral surface 11a of the inner dielectric portion 11 to the inner periphery of the outer dielectric portion 12 as illustrated in FIG. 5. However, the diameter of the hole 25 need not be equal to the width W1 from the outer peripheral surface 11a of the inner dielectric portion 11 to the inner periphery of the outer dielectric portion 12 when the waveguide satisfies desired characteristics. Alternatively, part of the via conductor 28 (the portion 28aa of the conductive portion 28a closest to the center of the inner dielectric portion 11 in FIG. 5) may be shifted from the plane 11aa formed by extending the outer peripheral surface 11a of the inner dielectric portion 11 in the direction along the outer peripheral surface 11a. In this case, the inner wall of the hole 25 corresponding to the diameter of the hole 25 corresponds to the surface with which the via conductor 28 is in contact. Specifically, as illustrated in FIGs. 14 and 15, the diameter of the hole 25 may be larger than the width W1.

In the example illustrated in FIG. 14, the center axis 25c of the hole 25 is shifted from the intermediate plane 20c of the perimeter portion 20 toward the outer dielectric portion 12 by a limited distance. In this case as well, a configuration in which the via conductor 28 does not protrude from the outer peripheral surface 11a of the inner dielectric portion 11 toward the center of the inner dielectric portion 11 and protrudes outward from the inner peripheral surface 12a of the outer dielectric portion 12 is possible when the waveguide satisfies desired characteristics.

In the example illustrated in FIG. 15, the center axis 25c of the hole 25 is shifted from the intermediate plane 20c of the perimeter portion 20 toward the inner dielectric portion 11 by a limited distance. In this case as well, a configuration in which the via conductor 28 does not protrude outward from the inner peripheral surface 12a of the outer dielectric portion 12 and protrudes from the outer peripheral surface 11a of the inner dielectric portion 11 toward the center of the inner dielectric portion 11 is possible when the waveguide satisfies desired characteristics. In the example illustrated in FIG. 15, the inner conductors 22 do not include the conductor protrusions 22b, and the inner dielectric portion 11 does not include the dielectric protrusions 11b.

Although not illustrated, the printed wiring board of the embodiment may include cases in which the center axis 25c of the hole 25 needs only to be positioned on the intermediate plane 20c of the perimeter portion 20 when the diameter of the hole 25 is larger than the width W1. In this case as well, as a possible configuration, the inner conductors 22 do not include the conductor protrusions 22b, the inner dielectric portion 11 does not include the dielectric protrusions 11b, the outer conductors 24 do not include the conductor protrusions 24b, and the outer dielectric portion 12 does not include the dielectric protrusions 12b, when the waveguide satisfies characteristics.

(3) When the diameter of the hole 25 is equal to the width W1 from the outer peripheral surface 11a of the inner dielectric portion 11 to the inner peripheral surface 12a of the outer dielectric portion 12, the position of the center axis 25c of the hole 25 may be shifted from the intermediate plane 20c of the perimeter portion 20 toward the inner dielectric portion 11 by a limited distance as long as the waveguide satisfies desired characteristics. In this case, the inner conductors 22 do not include the conductor protrusions 22b, and the inner dielectric portion 11 does not include the dielectric protrusions 11b. Although the next case is also not illustrated, when the diameter of the hole 25 is equal to the width W1 from the outer peripheral surface 11a of the inner dielectric portion 11 to the inner peripheral surface 12a of the outer dielectric portion 12, the position of the center axis 25c of the hole 25 may be shifted from the intermediate plane 20c of the perimeter portion 20 in the opposite direction, toward the outer dielectric portion 12, by a limited distance as long as the waveguide satisfies desired characteristics. In this case, the outer conductors 24 do not include the conductor protrusions 24b, and the outer dielectric portion 12 does not include the dielectric protrusions 12b.

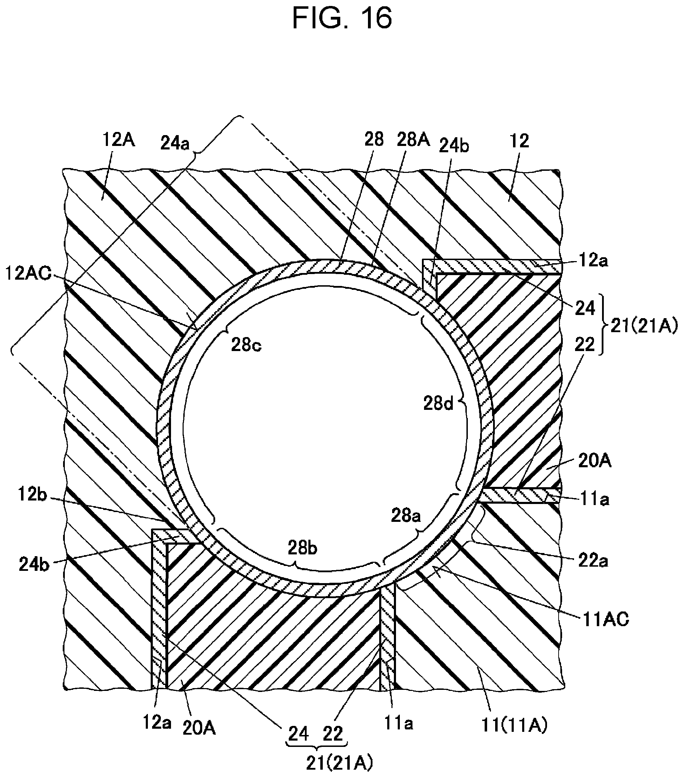

(4) For example, in the above description as illustrated in FIG. 7A, each slot 20A has an L shape forming a corner of the rectangular closed region 11A. Alternatively, each slot 20A may have a straight-line shape that corresponds to each of the four faces of the outer periphery of the closed region 11A. In this case, each connection portion 28A located between adjacent slots 20A link a portion of the corresponding corner 11AC of the closed region 11A to a portion of the corresponding corner 12AC of the outer region 12A. Hence, as illustrated in FIGs. 16 to 18, the hole 25 and the via conductor 28 are located in a region of the corner 11AC of the outer peripheral surface 11a of the inner dielectric portion 11 and a region of the corner 12AC of the inner peripheral surface 12a of the outer dielectric portion 12. The inner conductors 22 on both sides of the portion corresponding to the corner 11AC of the outer peripheral surface 11a of the inner dielectric portion 11 are electrically connected by the via conductor 28, and the outer conductors 24 on both sides of the portion corresponding to the corner 12AC of the inner peripheral surface 12a of the outer dielectric portion 12 are electrically connected by the via conductor 28.

In the example illustrated in FIG. 16, when the hole 25 is formed at the connection portion 28A, the hole 25 separates the metal plating layer 21A in each of the slots 20A extending from two directions toward the hole 25, into the inner conductor 22 and the outer conductor 24. In this case, the filling resin 26 in the slots 20A extending from the two directions toward the hole 25 is partially removed. Thus, the dielectric protrusions 11b are not formed at the corner 11AC of the outer peripheral surface 11a of the inner dielectric portion 11, and the inner conductors 22 do not include conductor protrusions 22b. In contrast, the corner 12AC of the inner peripheral surface 12a of the outer dielectric portion 12 includes dielectric protrusions 12b.

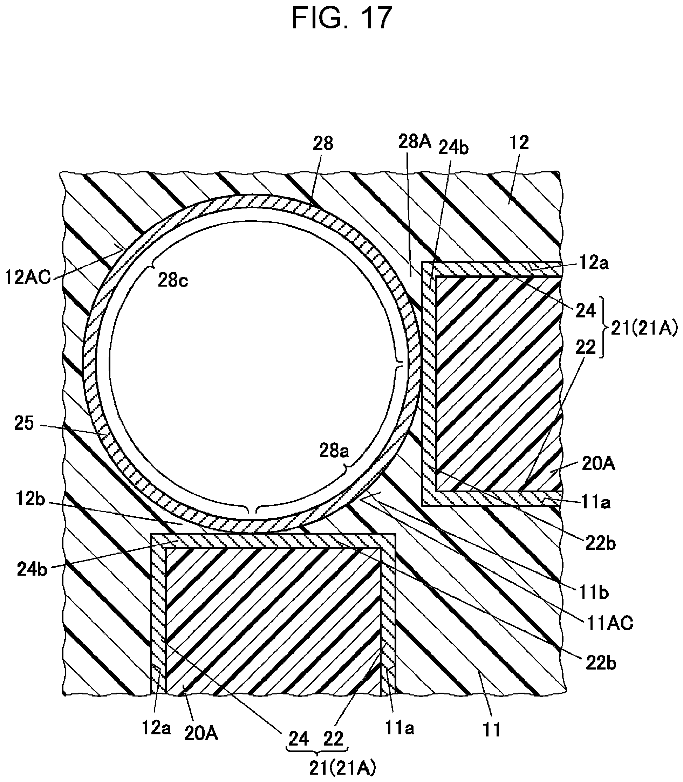

In the example illustrated in FIG. 17, when the hole 25 is formed at the connection portion 28A, the hole 25 does not separate the metal plating layer 21A in each of the slots 20A extending from two directions toward the hole 25, into the inner conductor 22 and the outer conductor 24, and the metal plating layers 21A are exposed to the inside of the hole 25. Thus, the conductor protrusions 22b of each inner conductor 22 are integrated with the conductor protrusions 24b of the corresponding outer conductor 24. Dielectric protrusions 11b are formed at the corner 11AC of the outer peripheral surface 11a of the inner dielectric portion 11. Dielectric protrusions 12b are formed at the corner 12AC of the inner peripheral surface 12a of the outer dielectric portion 12.

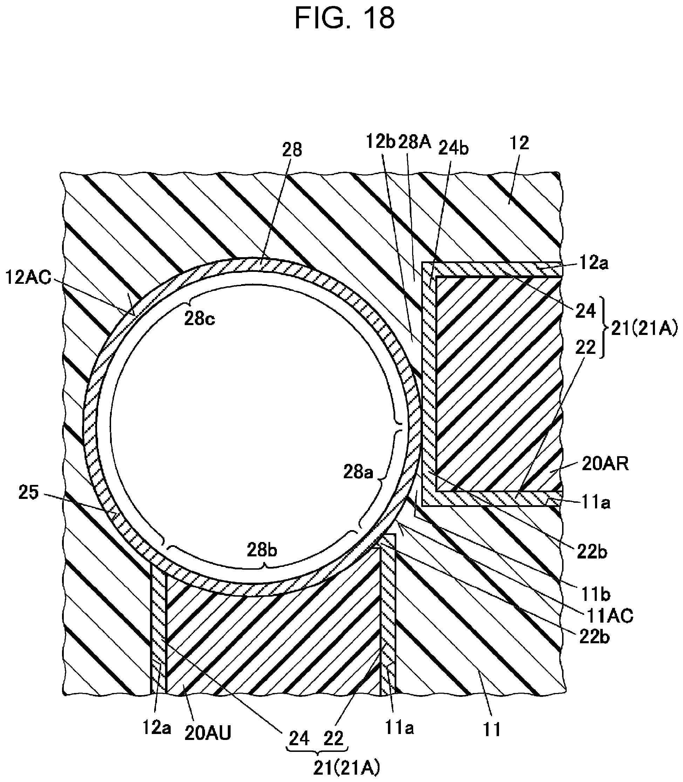

In the example illustrated in FIG. 18, when the hole 25 is formed at the connection portion 28A, the hole 25 does not separate the metal plating layer 21A on one side of the hole 25 (on the slot 20AR side) into the inner conductor 22 and the outer conductor 24, and the metal plating layer 21A is exposed to the inside of the hole 25. Thus, the conductor protrusion 22b of the unseparated inner conductor 22 is integrated with the conductor protrusion 24b of the unseparated outer conductor 24. When the hole 25 is formed at the connection portion 28A, the metal plating layer 21A on the other side (on the slot 20AU side) is separated by the hole 25 into the inner conductor 22 and the outer conductor 24. The separated inner conductor 22 includes a conductor protrusion 22b, and the separated outer conductor 24 does not include a conductor protrusion. Dielectric protrusions 11b are formed at the corner of the outer peripheral surface 11a of the inner dielectric portion 11. A dielectric protrusion 12b is formed at the corner of the inner peripheral surface 12a of the outer dielectric portion 12.

In the examples illustrated in FIGs. 17 and 18, care needs to be taken to ensure that the corresponding metal plating layer 21A is not separated into the inner conductor 22 and the outer conductor 24 by the hole 25 and that the hole 25 is not apart from the metal plating layer 21A. This is because if the hole 25 is apart from the metal plating layer 21A, the function as a ground conductor is degraded.

### [4. Advantageous Effects]

(1) Since the portion between adjacent inner conductors 22 is short-circuited by the via conductor 28, signal waves propagating in the thickness direction do not leak from the inner dielectric portion 11 through the discontinued portions 22a to the filling resin 26 and the outer dielectric portion 12. Thus, the transmission loss of signal waves is minimized.
(2) As illustrated in FIGs. 16 to 18, the via conductor 28 is located at the corner 11AC of the outer peripheral surface 11a of the inner dielectric portion 11 and the corner 12AC of the inner peripheral surface 12a of the outer dielectric portion 12. Hence, the four faces of the outer peripheral surface 11a of the inner dielectric portion 11 are flat. This contributes to reducing the non-uniformity of the characteristic impedance in the inner dielectric portion 11 and improving the gain in the inner dielectric portion 11. As illustrated in FIG. 16, since the corner 11AC of the outer periphery of the inner dielectric portion 11 is rounded, noise is less likely to be generated on signal waves.
(3) Since the portion between adjacent outer conductors 24 is short-circuited by the via conductor 28, the outer conductor 24 reinforces the effects of the inner conductors 22 on reducing signal wave leakage.
(4) Since the portion between the inner conductor 22 and the outer conductor 24 is filled with the filling resin 26, the inner dielectric portion 11 does not fall off from the outer dielectric portion 12. Before the filling resin 26 is formed after the slots 20A are formed, the connection portions 28A link the closed region 11A and the outer region 12A. Hence, the closed region 11A does not fall off from the outer region 12A.
(5) The conductive portions 28b and 28d of the via conductor 28 are formed in the hole 25 on the filling resin 26 in the width direction from the outer peripheral surface 11a of the inner dielectric portion 11 toward the inner peripheral surface 12a of the outer dielectric portion 12. This reinforces the electrical connection between the via conductor 28 and the enclosure conductors 21, and also improves the mechanical strength of the enclosure conductors 21 in the width direction from the outer peripheral surface 11a of the inner dielectric portion 11 toward the inner peripheral surface 12a of the outer dielectric portion 12. This helps to avoid the disconnection between the via conductors 28 and the enclosure conductors 21 when the printed wiring board 1 is deformed by a mechanical load and also contributes to improving the reliability of signal wave transmission.
(6) The inner conductors 22 are formed on the outer peripheral surface 11a of the inner dielectric portion 11 throughout the entire thickness of the dielectric layer 10 from the first surface 10a to the second surface 10b. The outer conductors 24 are formed on the inner peripheral surface 12a of the outer dielectric portion 12 throughout the entire thickness of the dielectric layer 10 from the first surface 10a to the second surface 10b. This reduces the leakage of signal waves propagating in the thickness direction and minimizes the transmission loss of the signal waves.
(7) The inner conductors 22 include the conductor protrusions 22b at the edges forming the discontinued portions 22a. Since the conductor protrusion 22b is wedged into the boundary between the dielectric protrusion 11b of the inner dielectric portion 11 and the filling resin 26, the conductor protrusion 22b contributes to improving the strength of the perimeter portion 20 in the peripheral direction of the outer peripheral surface 11a of the inner dielectric portion 11 or the inner peripheral surface 12a of the outer dielectric portion 12 and in the width direction from the outer peripheral surface 11a of the inner dielectric portion 11 to the inner periphery of the outer dielectric portion 12. In addition, since the conductor protrusions 22b are composed of a metal having a higher Young's modulus and a lower thermal expansion coefficient than resins, the conductor protrusions 22b contribute to improving the strength of the perimeter portion 20 in the peripheral direction and the width direction mentioned in this paragraph. Similarly, the conductor protrusions 24b of the outer conductors 24 contribute to improving the strength of the perimeter portion 20 in the peripheral direction and the width direction mentioned in this paragraph. When the printed wiring board 1 is deformed by a mechanical load, the conductor protrusions 22b and 24b help to avoid the disconnection between the via conductors 28 and the enclosure conductors 21 and contribute to reducing the transmission loss of signal waves.
(8) Since the inner dielectric portion 11 and the outer dielectric portion 12 undergo the same steps and are cured and formed at the same time, the inner dielectric portion 11 and the outer dielectric portion 12 have the same dielectric properties. Thus, the transmission loss of signal waves can be reduced in the inner dielectric portion 11.
(9) As illustrated in FIGs. 5, 12, 13, 14, 17, and 18, the via conductor 28 does not protrude from the outer peripheral surface 11a of the inner dielectric portion 11 toward the center of the inner dielectric portion 11. Thus, signal waves propagating in the inner dielectric portion 11 in the thickness direction are less likely to be reflected diffusedly by the via conductors 28. Thus, the transmission loss of signal waves can be reduced in the inner dielectric portion 11.

### <<Second Embodiment>>

### [1. Printed Wiring Board]

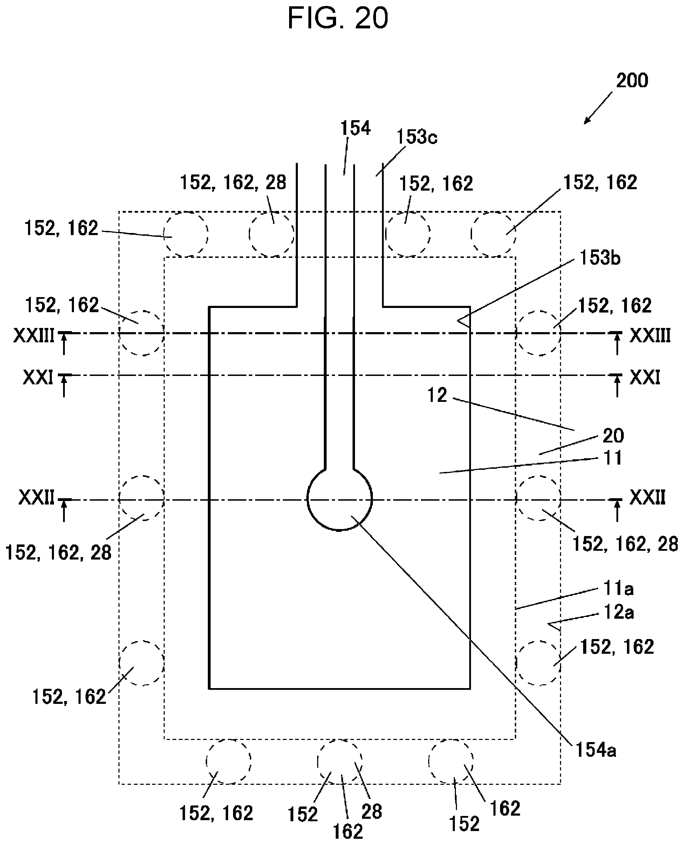

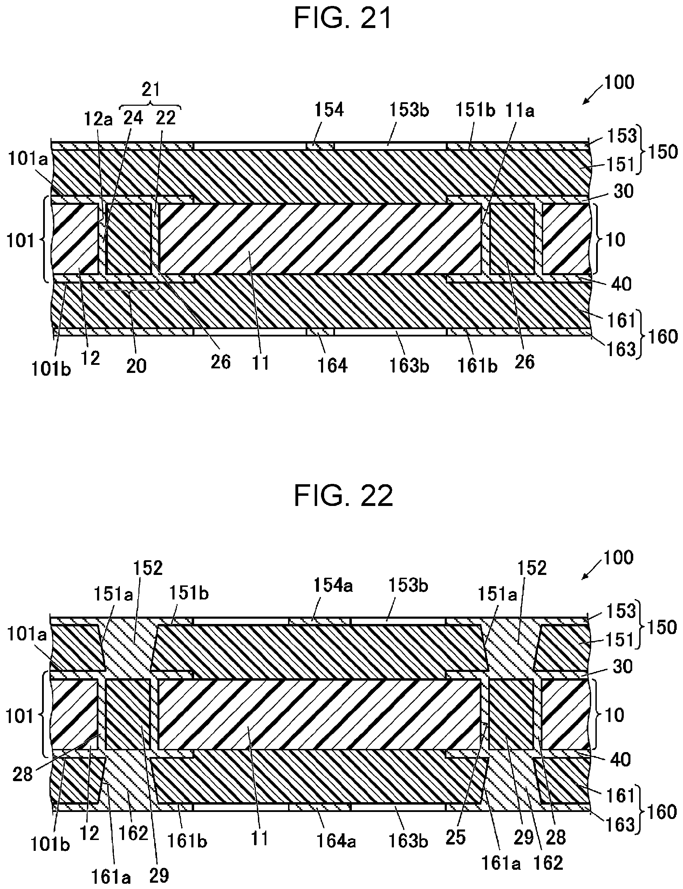

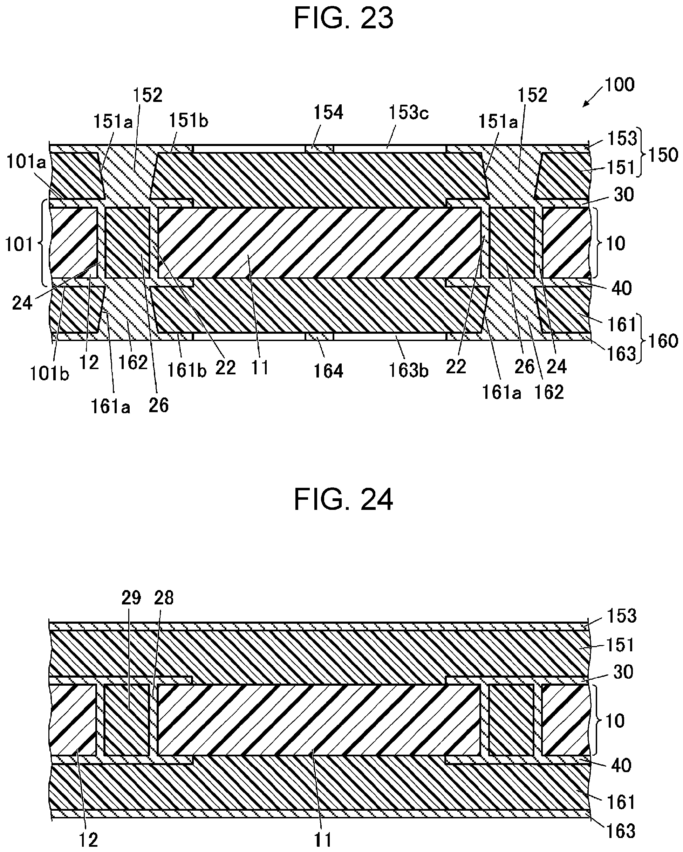

A printed wiring board 100 will be described with reference to FIGs. 19 to 23. FIG. 19 is a perspective view of the printed wiring board 100. FIG. 20 is a plan view of the printed wiring board 100. FIG. 21 is a cross-sectional view taken along line XXI-XXI in FIG. 20. FIG. 22 is a cross-sectional view taken along line XXII-XXII in FIG. 20. FIG. 23 is a cross-sectional view taken along line XXIII-XXIII in FIG. 20. FIG. 19 illustrates part of the printed wiring board 100, which extends in a range larger than the range illustrated in FIG. 1.

The printed wiring board 100 is a multilayer board. The printed wiring board 100 includes a core board 101, a first build-up layer 150, and a second build-up layer 160. The second build-up layer 160, the core board 101, and the first build-up layer 150 are positioned in this order in a stacked structure.

The core board 101 has the same or a similar configuration as the printed wiring board 1 of the first embodiment. The components of the core board 101 are the same as the corresponding components of the printed wiring board 1. Hence, the components of the core board 101 are denoted by the same reference signs as the corresponding components of the printed wiring board 1, and detailed description of the components of the core board 101 is omitted.

Note that the insides of the via conductors 28 are filled with filling resin 29.

The first build-up layer 150 includes a dielectric layer 151, multiple via conductors 152, and a surface conductor layer 153.

The dielectric layer 151 is stacked on a first surface 101a of the core board 101. The first surface 101a of the core board 101 means the surface of the conductor layer 30 of the core board 101 and the portions of the first surface 10a of the dielectric layer 10 of the core board 101 that are not covered with the conductor layer 30. Specifically, the dielectric layer 151 not only covers the conductor layer 30 but also covers the portions of the first surface 10a of the dielectric layer 10 that are not covered with the conductor layer 30.

The dielectric layer 151 is composed of a material having dielectric properties. Examples of such materials having dielectric properties include organic resins such as liquid crystal polymer, epoxy resin, bismaleimide-triazine resin, polyimide resin, polyphenylene ether (PPE) resin, polyphenylene oxide (PPO) resin, and cyanate ester resin. Two or more of these organic resins may be mixed. One or two or more of these organic resins may be blended with a reinforcement material. Examples of reinforcement materials include glass fibers, glass nonwoven fabrics, aramid fibers, aramid nonwoven fabrics, polyester fibers, and polyester nonwoven fabrics. One or two or more of these organic resins may contain inorganic fillers such as barium sulfate, talc, clay, glass, calcium carbonate, and titanium, for example.

The via conductors 152 pass through the dielectric layer 151 in the thickness direction. Specifically, the dielectric layer 151 includes multiple holes 151a extending through the dielectric layer 151 in the thickness direction, and each hole 151a is filled with the via conductor 152. The material of the via conductors 152 is a conductive metal, for example, copper. The via conductors 152 are coupled to the conductor layer 30 of the core board 101 and also electrically connected to the conductor layer 30.

The multiple via conductors 152 are arranged at intervals along the outer peripheral surface 11a of the inner dielectric portion 11. These via conductors 152 overlap the perimeter portion 20 as viewed in the thickness direction. Some of these via conductors 152 overlap the corresponding ones of the via conductors 28 as viewed in the thickness direction. In the region surrounded by these via conductors 152 in the dielectric layer 151, signal waves propagate in the thickness direction. The distances between these via conductors 152 are shorter than one tenth of the wavelength of the signal waves, and thus the signal waves are less likely to leak through the regions between the via conductors 152.

The surface conductor layer 153 is stacked on a surface 151b of the dielectric layer 151 that is on the opposite side of the dielectric layer 151 from the core board 101. The surface conductor layer 153 is electrically connected to the via conductors 152. The surface conductor layer 153 includes an opening 153b and a slit 153c. The opening 153b is located at a position overlapping the ports 31 and 41 as viewed in the thickness direction. The opening 153b is rectangular, and each of the four sides of the opening 153b is parallel to the corresponding one of the four sides of the port 31. The surface conductor layer 153 is grounded.

The slit 153c linearly extends in a surface direction, and one end of the slit 153c is connected to the opening 153b.

A signal line 154 is formed in the slit 153c and on the surface 151b of the dielectric layer 151. The signal line 154 linearly extends along the slit 153c to a point inside the opening 153b. The signal line 154 includes a pad 154a having a diameter larger than the width of the signal line 154 at an end portion of the signal line 154 in the opening 153b. The signal line 154 is electrically insulated from the surface conductor layer 153. Since the surface conductor layer 153 is present on both sides of the signal line 154, the signal line 154 is a coplanar line. Note that the signal line 154 may be a microstrip line.

The second build-up layer 160 includes a dielectric layer 161, multiple via conductors 162, and a surface conductor layer 163.

The dielectric layer 161 is stacked on a second surface 101b of the core board 101. The second surface 101b of the core board 101 means the surface of the conductor layer 40 of the core board 101 and the portions of the second surface 10b of the dielectric layer 10 of the core board 101 that are not covered with the conductor layer 40. Specifically, the dielectric layer 161 not only covers the conductor layer 40 but also covers the portions of the second surface 10b of the dielectric layer 10 that are not covered with the conductor layer 40.

The dielectric layer 161 is composed of a material having dielectric properties in the same or a similar manner as the dielectric layer 151. The materials listed as examples of materials for the dielectric layer 151 are used as the material of the dielectric layer 161. The material of the dielectric layer 161 may be the same as or different from the material of the dielectric layer 151.

The dielectric layer 161 includes multiple holes 161a extending through the dielectric layer 161 in the thickness direction. The holes 161a are filled with the via conductors 162, which pass through the dielectric layer 161 in the thickness direction. The via conductors 162 are coupled to the conductor layer 40 of the core board 101 and also electrically connected to the conductor layer 30.

The multiple via conductors 162 are arranged at intervals along the outer peripheral surface 11a of the inner dielectric portion 11. These via conductors 162 overlap the perimeter portion 20 as viewed in the thickness direction. Some of these via conductors 162 overlap the corresponding ones of the via conductors 28 as viewed in the thickness direction.

The surface conductor layer 163 is stacked on a surface 161b of the dielectric layer 161 that is on the opposite side of the dielectric layer 161 from the core board 101. The surface conductor layer 163 is electrically connected to the via conductors 162. In the same or a similar manner as the surface conductor layer 153, the surface conductor layer 163 also includes an opening 163b and a slit. A signal line 164 as a coplanar line is formed in the slit of the surface conductor layer 163 and on the surface 161b of the dielectric layer 161. The signal line 164 linearly extends along the slit of the surface conductor layer 163 to a point inside the opening 163b. The signal line 164 includes a pad 164a at its end portion in the opening 163b, and the pad 164a is electromagnetically coupled to the pad 154a of the signal line 154 with the dielectric layer 161, the inner dielectric portion 11, and the dielectric layer 151 interposed therebetween. Note that the signal line 164 may be a microstrip line.

When signal waves are transmitted by the signal line 154 along the signal line 154 to the pad 154a, the signal waves are transmitted in the thickness direction from the pad 154a through the dielectric layer 151, the inner dielectric portion 11, and the dielectric layer 161 to the pad 164a of the signal line 164. The signal waves are transmitted from the pad 164a by the signal line 164.

Note that although the illustration is omitted, the signal line 154 is connected to a radio frequency integrated circuit (RFIC) and one end of an antenna, and the signal line 164 is connected to the other end.

### [2. Method for Manufacturing Printed Wiring Board]

Next, a method for manufacturing the printed wiring board 100 will be described with reference to FIGs. 24 to 26. The positions of the cross sections in FIGs. 24 to 26 are the same as the position of the cross section in FIG. 22.

### (1) Preparation of Core Board

A core board 101 is prepared. Specifically, a core board 101 is produced in the same or a similar way as in the method for manufacturing the printed wiring board 1 of the first embodiment. Specifically, the steps from "(1) Preparation" to "(7) Formation of Ports" in the method for manufacturing the printed wiring board 1 of the first embodiment are performed. Although filling the insides of the via conductors 28 with filling resin and covering the filling resin in the via conductors 28 with the conductor layer 30 are optional in the first embodiment, filling the insides of the via conductors 28 with filling resin and covering the filling resin in the via conductors 28 with the conductor layer 30 are indispensable in the second embodiment.

### (2) Stacking Dielectric Layers and Surface Conductor Layers

Next, as illustrated in FIG. 24, the dielectric layer 151 and the dielectric layer 161 are stacked on the first surface 101a and the second surface 101b, respectively, of the core board 101. Then, the surface conductor layers 153 and 163 are formed on the dielectric layers 151 and 161, respectively, by electroless plating or vapor deposition, for example. Alternatively, copper foils are overlayed and stacked on the dielectric layer 151 and the dielectric layer 161. Regarding the step of stacking the dielectric layer 151 and the dielectric layer 161 on the first surface 101a and the second surface 101b, respectively, of the core board 101 and the step of forming the surface conductor layers 153 and 163 on the dielectric layer 151 and the dielectric layer 161, respectively, either step may be performed first, or they may be performed simultaneously.

### (3) Hole Formation

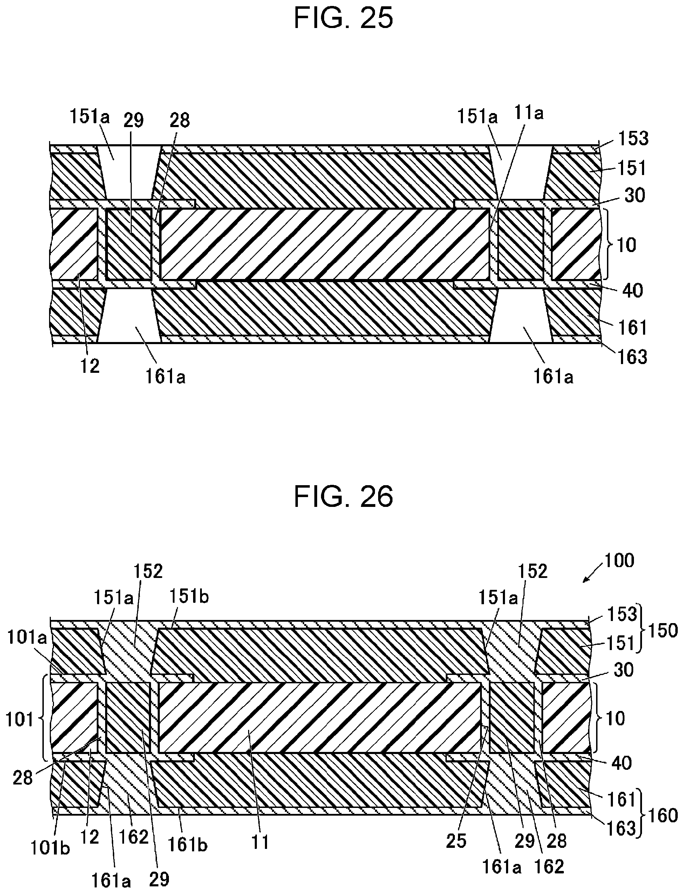

Next, as illustrated in FIG. 25, multiple holes 151a are formed to extend through the surface conductor layer 153 and the dielectric layer 151 from the surface conductor layer 153 to the first surface 101a of the core board 101. When these holes 151a are formed, these holes 151a are arranged between the outer peripheral surface 11a of the inner dielectric portion 11 and the inner peripheral surface 12a of the outer dielectric portion 12 at intervals along the outer peripheral surface 11a and the inner peripheral surface 12a. The holes 151a are formed by etching or laser beam drilling.

Similarly, multiple holes 161a are formed to extend through the surface conductor layer 163 and the dielectric layer 161 from the surface conductor layer 163 to the second surface 101b of the core board 101.

Note that desmearing may be performed to remove smears in the holes 151a and 161a.

### (4) Plating

Next, as illustrated in FIG. 26, a plating process is performed on the multilayer body including the surface conductor layer 163, the dielectric layer 161, the core board 101, the dielectric layer 151, and the surface conductor layer 153 to form the via conductors 152 and 162 in the holes 151a and 161a. This plating process grows also the surface conductor layers 153 and 163, increasing their thickness, electrically connects the via conductors 152 to the surface conductor layer 153, and electrically connects the via conductor layer 163 to the surface conductor layer 163. Note that for this plating, filled plating for filling the holes 151a and 161a with a conductive material may be used.

### (5) Patterning

Next, the surface conductor layers 153 and 163 are covered with masks, and the surface conductor layers 153 and 163 are patterned by etching, so that the slit 153c and the opening 153b are formed in the surface conductor layer 153, and the slit 163c and the opening 163b are formed in the surface conductor layer 163 (see FIGs. 19 to 23). In this process, the signal lines 154 and 164 remain so as to be separated from the surface conductor layers 153 and 164, respectively.

Although (4) and (5) mentioned above are an example of a subtractive method, the patterning may be performed by pattern plating using the inverse masks opposite to the masks mentioned above by an MSAP that uses a copper foil as a seed layer or a semi-additive method that uses electroless copper plating as a seed layer.

### [3. Advantageous Effects]

Since the portions between adjacent inner conductors 22 are short-circuited by the via conductors 28, signal waves propagate efficiently from the signal line 154 to the signal line 164 without leaking. In addition, the advantageous effects provided in the first embodiment are also provided in the second embodiment.

### <<Third Embodiment>>

### [1. Printed Wiring Board]

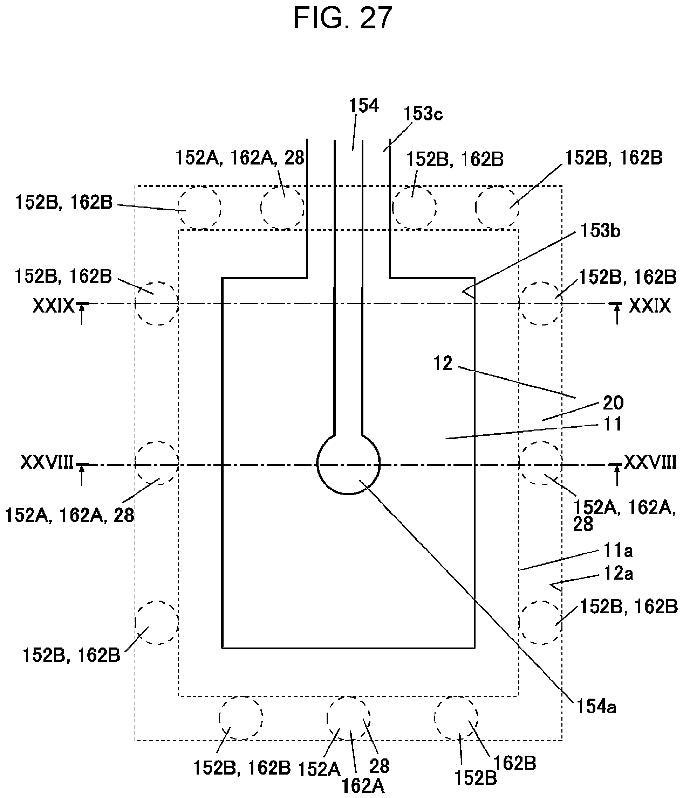

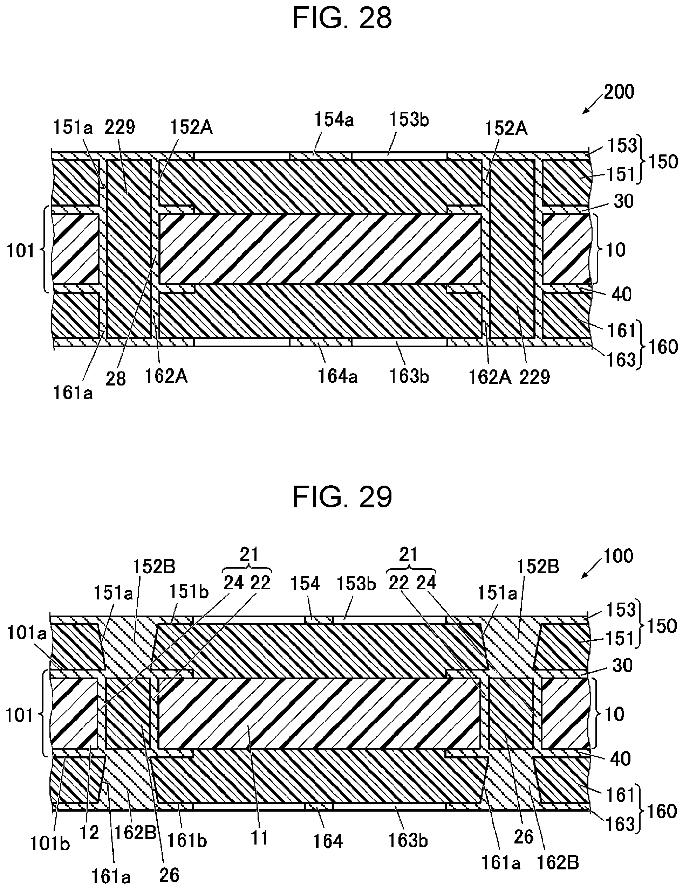

A printed wiring board 200 will be described with reference to FIGs. 27 to 29. FIG. 27 is a plan view of the printed wiring board 200. FIG. 28 is a cross-sectional view taken along line XXVIII-XXVIII in FIG. 27. FIG. 29 is a cross-sectional view taken along line XXIX-XXIX in FIG. 27. The components of the printed wiring board 200 in the third embodiment are denoted by the same reference signs as the corresponding components of the printed wiring board 100 in the second embodiment.

The printed wiring board 200 of the third embodiment differs from the printed wiring board 100 of the second embodiment in the following points, except which the printed wiring board 200 of the third embodiment is the same as the printed wiring board 100 of the second embodiment.

In the printed wiring board 100 of the second embodiment, all of the via conductors 152 and 162 are so-called filled via conductors composed of plating formed in the holes 151a and 161a.

In the printed wiring board 200 of the third embodiment, unlike the second embodiment, the via conductors 152A and 162A that overlap the via conductors 28, out of the via conductors 152 and 162, are conformal via conductors formed on the inner surfaces of the holes 151a and 161a. In addition, the via conductors 152A and 162A that overlap the via conductors 28 are integrated with the via conductors 28, and these via conductors 152A, 28, and 162A connected in the thickness direction form through-hole conductors. The via conductors 152B and 162B that do not overlap the via conductors 28, out of the via conductors 152 and 162, are filled via conductors.

In the printed wiring board 200 of the third embodiment, filling resin 229 in the through-hole conductors composed of the via conductors 152A, 28, and 162A is covered with the surface conductor layers 153 and 163. Note that a configuration without the filling resin 229 is also possible. In this case, the via conductors 152A are open in the surface conductor layer 153, and the via conductors 162A are open in the surface conductor layer 163.

### [2. Method for Manufacturing Printed Wiring Board]

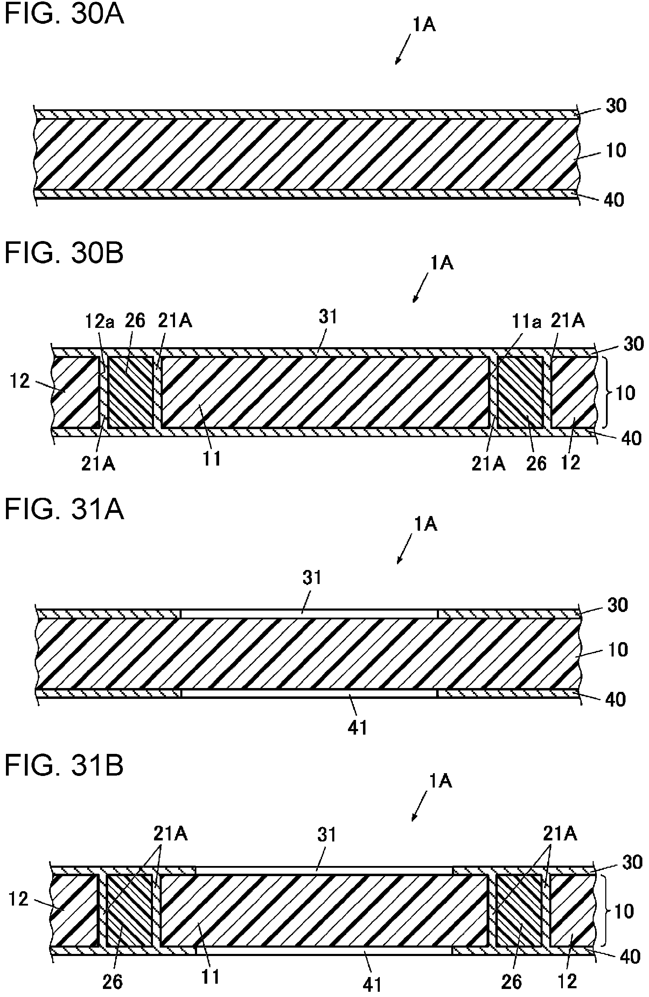

A method for manufacturing the printed wiring board 200 will be described with reference to FIGs. 30A to 35A, 37A, 30B to 32B, 36B, and 37B. The positions of the cross sections in FIGs. 30A to 35A, and 37A are the same as the position of the cross section in FIG. 28. The positions of the cross sections in FIGs. 30B to 32B, 36B, and 37B are the same as the position of the cross section in FIG. 29.

### (1) Same or Similar Steps as in First Embodiment

In the same or a similar way as in the manufacturing method in the first embodiment, the same or similar steps as those described in "(1) Preparation", "(2) Formation of Slots", "(3) Plating", and "(4) Resin Filling" are performed (see FIGs. 6A to 9A and 6B to 9B).

### (2) Plating

After that, as illustrated in FIGs. 30A and 30B, a plating process is performed on the multilayer body 1A, so that plating grows also on the conductor layers 30 and 40, increasing their thickness. In this process, plating grows also on the surface of the filling resin 26, so that the filling resin 26 is covered with the conductor layers 30 and 40.

### (3) Formation of Ports

Next, the conductor layers 30 and 40 are covered with masks, and the regions of the conductor layers 30 and 40 corresponding to the inner dielectric portion 11 are removed by etching, so that the ports 31 and 41 are formed in the conductor layers 30 and 40, respectively, as illustrated in FIGs. 31A and 31B. When the ports 31 and 41 are formed, wiring patterns may be formed in regions of the conductor layers 30 and 40 away from the ports 31 and 41.

### (4) Stacking Dielectric Layers and Surface Conductor Layers

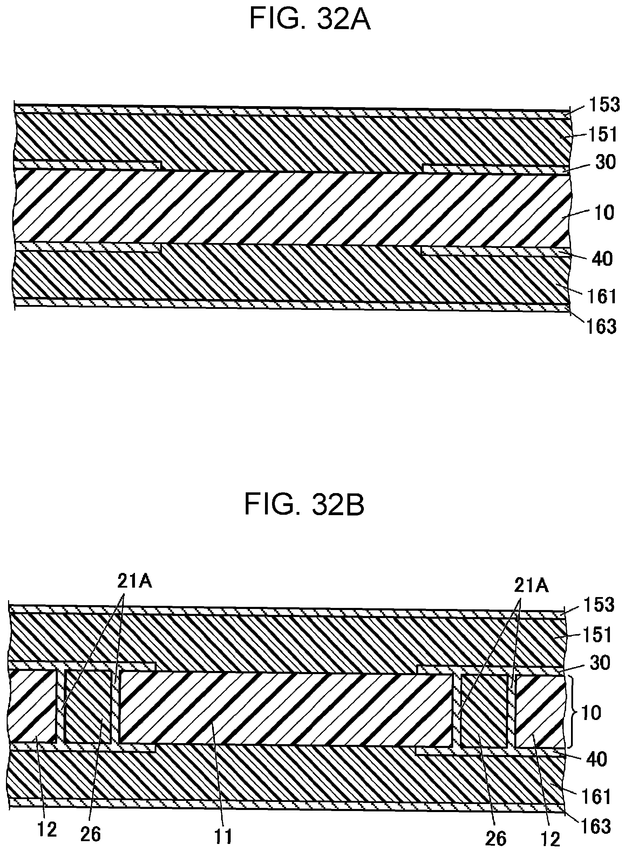

Next, as illustrated in FIGs. 32A and 32B, the dielectric layer 151 and the dielectric layer 161 are stacked on the conductor layer 30 and the conductor layer 40, respectively, and then, the surface conductor layers 153 and 163 are formed on the dielectric layers 151 and 161, respectively, by electroless plating or vapor deposition, for example. Alternatively, copper foils are overlayed and stacked on the dielectric layer 151 and the dielectric layer 161. Regarding the step of stacking the dielectric layer 151 and the dielectric layer 161 on the conductor layer 30 and the conductor layer 40, respectively, and the step of stacking the surface conductor layers 153 and 163 on the dielectric layer 151 and the dielectric layer 161, respectively, either step may be performed first, or they may be performed simultaneously.

### (5) Formation of Through Holes

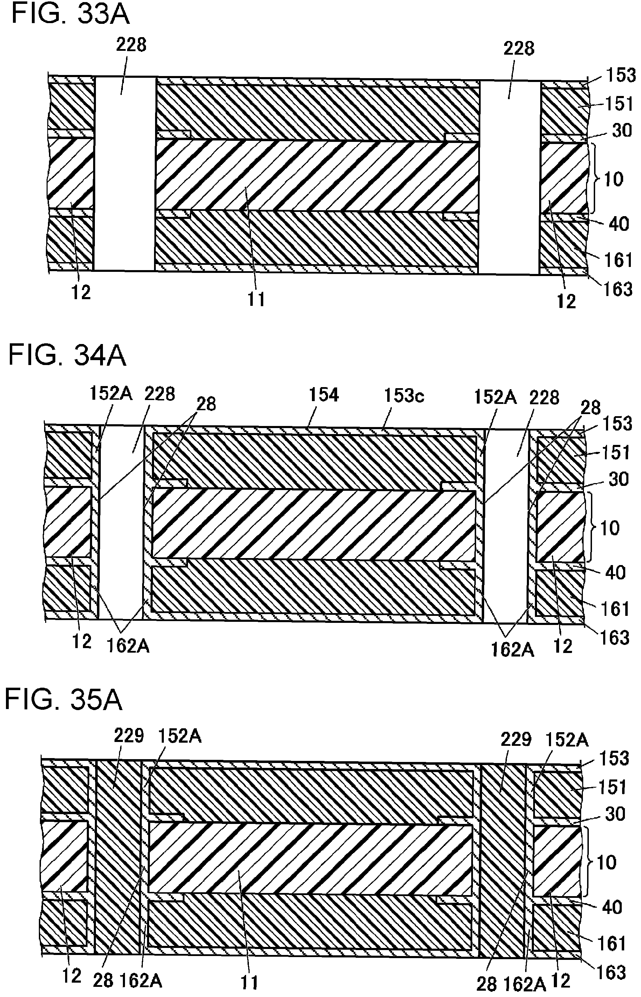

Next, as illustrated in FIG. 33A, multiple through holes 228 are formed to extend from the surface conductor layer 153 through to the surface conductor layer 163. The positions of the through holes 228 overlap the positions of the connection portions 28A as viewed in the thickness direction. Hence, by forming the through holes 228, the connection portions 28A are cut off by the through holes 228, and the dielectric layer 10 is separated into the inner dielectric portion 11 and the outer dielectric portion 12. Of each through hole 228, the portion extending through the dielectric layer 10 corresponds to the hole 25, the portion extending through the dielectric layer 151 corresponds to the hole 151a, and the portion extending through the dielectric layer 161 corresponds to the hole 161a. The through holes 228 are formed by etching, laser beam drilling, sand blast drilling, liquid jet drilling, or mechanical drilling. Examples of tools that are used in mechanical drilling include drills.

### (6) Plating

Next, as illustrated in FIG. 34A, a plating process is performed on the multilayer body including the surface conductor layer 163, the dielectric layer 161, the conductor layer 40, the dielectric layer 10, the conductor layer 30, the dielectric layer 151, and the surface conductor layer 153. This process forms a via conductor 152A, the via conductor 28, and a via conductor 162A integrally on the inner surface of each through hole 228. The plating process mentioned above grows also plating on the surface conductor layers 153 and 163, increasing their thickness, electrically connects the via conductors 152A to the surface conductor layer 153, and electrically connects the via conductors 162A to the surface conductor layer 163.

Alternatively, this plating step may be omitted by forming the via conductor 152A, the via conductor 28, and the via conductor 162A on the inner surface of each through hole 228 in the plating step (9) performed later.

### (7) Resin Filling

Next, as illustrated in FIG. 35A, the insides of the via conductors 152A, the via conductors 28, and the via conductors 162A are filled with resin, and the resin is cured. This process forms the filling resin 229. A configuration without the filling resin 229 by omitting this step is also possible. When the plating step (6) is omitted, the formation of the filling resin 229 is also omitted.

### (8) Hole Formation

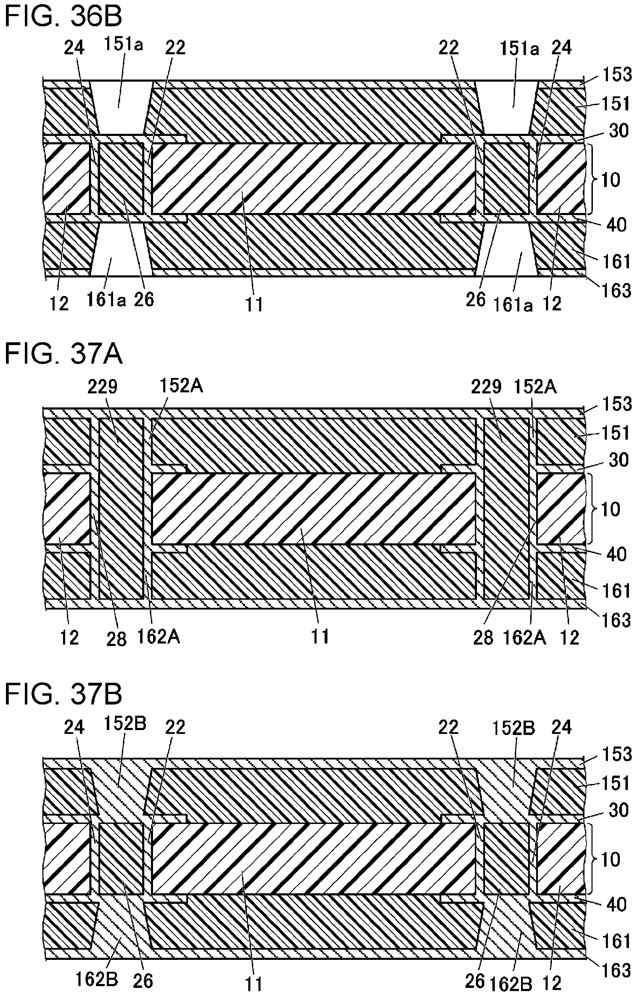

Next, as illustrated in FIG. 36B, the multiple holes 151a are formed to extend through the surface conductor layer 153 and the dielectric layer 151 from the surface conductor layer 153 to the conductor layer 30. When these holes 151a are formed, these holes 151a are arranged between the outer peripheral surface 11a of the inner dielectric portion 11 and the inner peripheral surface 12a of the outer dielectric portion 12 at intervals along the outer peripheral surface 11a and the inner peripheral surface 12a. The holes 151a are formed by etching or laser beam drilling.

Similarly, the multiple holes 161a are formed to extend through the surface conductor layer 163 and the dielectric layer 161 from the surface conductor layer 163 to the conductor layer 40.

Note that the holes 151a and 161a formed in this step are not connected to the holes 25; in other words, they are not part of the through holes 228.

### (9) Plating

Next, as illustrated in FIGs. 37A and 37B, a plating process is performed on the multilayer body including the surface conductor layer 163, the dielectric layer 161, the conductor layer 40, the dielectric layer 10, the conductor layer 30, the dielectric layer 151, and the surface conductor layer 153. This process forms the via conductors 152B and 162B in the holes 151a and 161a that are not connected to the holes 25. The plating process mentioned above forms plating films also on the surface conductor layers 153 and 163, increasing their thickness, and the filling resin 229 is covered with the surface conductor layers 153 and 163. In addition, the via conductors 152B are electrically connected to the surface conductor layer 153, and the via conductor layer 163B is electrically connected to the surface conductor layer 163.

Note that for this plating, filled plating for filling the holes 151a and 161a with a conductive material may be used.

### (10) Patterning

Next, the surface conductor layers 153 and 163 are covered with masks, and the surface conductor layers 153 and 163 are patterned by etching, so that the slit 153c and the opening 153b are formed in the surface conductor layer 153, and the slit 163c and the opening 163b are formed in the surface conductor layer 163. In this process, the signal lines 154 and 164 remain so as to be separated from the surface conductor layers 153 and 164, respectively.

Although (9) and (10) mentioned above are an example of a subtractive method, the patterning may be performed by pattern plating using the inverse masks opposite to the masks mentioned above by an MSAP that uses a copper foil as a seed layer or a semi-additive method that uses electroless copper plating as a seed layer.

### <<Appendix>>

Specific details illustrated in the above embodiments such as the configurations, structures, positional relationship, and shapes may be changed as appropriate within a scope not departing from the spirit of the present disclosure. In addition, the configurations, structures, positional relationship, and shapes illustrated in the above embodiments may be combined as appropriate within a scope not departing from the spirit of the present disclosure.

In an embodiment, (1) a printed wiring board includes: a dielectric layer; multiple inner conductors; and multiple via conductors, the dielectric layer includes first and second surfaces facing away from each other and extending in surface directions, includes an inner dielectric portion having a shape of a closed region extending in the surface directions, and includes an outer dielectric portion located outside the inner dielectric portion in the surface directions and surrounding the inner dielectric portion, the multiple inner conductors are formed on an outer periphery of the inner dielectric portion and arranged with a gap between adjacent inner conductors of the multiple inner conductors in a peripheral direction of the outer periphery on the outer periphery of the inner dielectric portion, the via conductors are arranged between the outer periphery of the inner dielectric portion and an inner periphery of the outer dielectric portion at intervals in the peripheral direction, and each of the via conductors is located between adjacent inner conductors of the inner conductors on the outer periphery of the inner dielectric portion and connected to the adjacent inner conductors.

(2) In the printed wiring board according to (1) mentioned above, the outer periphery of the inner dielectric portion and the inner periphery of the outer dielectric portion are rectangular, and each of the via conductors is located at a different corner of the outer periphery of the inner dielectric portion and a corresponding corner of the outer periphery of the outer dielectric portion.

(3) The printed wiring board according to (1) or (2) mentioned above further includes multiple outer conductors located on the inner periphery of the outer dielectric portion and arranged with a gap between adjacent outer conductors of the multiple outer conductors in the peripheral direction on the inner periphery of the outer dielectric portion, and each of the via conductors is located between adjacent outer conductors of the outer conductors on the inner periphery of the outer dielectric portion and connected to the adjacent outer conductors.

(4) The printed wiring board according to (3) mentioned above further includes multiple filling resin portions located between the outer periphery of the inner dielectric portion and the inner periphery of the outer dielectric portion and between the inner conductors and the outer conductors.

(5) In the printed wiring board according to (4) mentioned above, each of the via conductors includes a conductive portion electrically connecting corresponding inner and outer conductors of the inner conductors and the outer conductors in a width direction from the outer periphery of the inner dielectric portion toward the inner periphery of the outer dielectric portion.

(6) In the printed wiring board according to any one of (1) to (5) mentioned above, the inner conductors are formed on the outer periphery of the inner dielectric portion throughout entire thickness of the dielectric layer from the first surface to the second surface.

(7) In the printed wiring board according to any one of (1) to (6) mentioned above, each of the inner conductors includes a conductor protrusion protruding in a direction from the inner dielectric portion toward the outer dielectric portion and connected to a corresponding one of the via conductors.

(8) In the printed wiring board according to (3) or (4) mentioned above, each of the outer conductors includes a conductor protrusion protruding in a direction from the outer dielectric portion toward the inner dielectric portion and connected to a corresponding one of the via conductors.

(9) The printed wiring board according to any one of (1) to (8) mentioned above further includes: a first conductor layer stacked on the first surface, grounded, and including a first port at a position overlapping the inner dielectric portion; and a second conductor layer stacked on the second surface, grounded, and including a second port at a position overlapping the inner dielectric portion, the via conductors are connected to the first conductor layer and the second conductor layer, and the inner dielectric portion and the outer dielectric portion have a same dielectric property.

(10) In the printed wiring board according to any one of (1) to (9) mentioned above, the via conductors do not protrude from the outer periphery of the inner dielectric portion toward a center of the inner dielectric portion, and the closed region is rectangular.

(11) The printed wiring board according to (9) mentioned above further includes a build-up layer stacked on the first conductor layer, the build-up layer includes: a second dielectric layer stacked on the first conductor layer; and a surface conductor layer stacked on the second dielectric layer, and the surface conductor layer includes a signal line extending to a position overlapping the first port.

In an embodiment, (12) a method for manufacturing a printed wiring board includes: forming multiple slots in a dielectric layer including first and second surfaces facing away from each other and extending in surface directions, the multiple slots surrounding a closed region, extending in the surface directions, of the dielectric layer and extending through the dielectric layer from the first surface to the second surface around the closed region; forming metal plating layers on inner surfaces of the slots; filling spaces on inner sides of the metal plating layers in the slots with resin, and curing the resin; forming holes extending from the first surface to the second surface, each hole located in a portion between adjacent slots of the slots in the dielectric layer; and forming via conductors on inner surfaces of the holes and electrically connecting the via conductors to the metal plating layers.

### REFERENCE SIGNS

1, 100, 200 printed wiring board
10 dielectric layer
10a first surface
10b second surface
11 inner dielectric portion
11a outer periphery
12 outer dielectric portion
12a inner periphery
21A metal plating layer
22 inner conductor
22b conductor protrusion
24 outer conductor
24b conductor protrusion
26 filling resin
28 via conductor
28b, 28d conductive portion
30 conductor layer (first conductor layer)
40 conductor layer (second conductor layer)
150 build-up layer
151 dielectric layer (second dielectric layer)
153 surface conductor layer
154 signal line

## Claims

1. A printed wiring board comprising:
a dielectric layer;
multiple inner conductors; and
multiple via conductors, wherein
the dielectric layer
comprises first and second surfaces facing away from each other and extending in surface directions,
comprises an inner dielectric portion having a shape of a closed region extending in the surface directions, and interval
comprises an outer dielectric portion located outside the inner dielectric portion in the surface directions and surrounding the inner dielectric portion,
the multiple inner conductors are located on an outer periphery of the inner dielectric portion and are spaced apart from one another in the circumferential direction of the outer periphery,
the via conductors are located between the outer periphery of the inner dielectric portion and an inner periphery of the outer dielectric portion and are spaced apart from one another in the circumferential direction of the outer periphery, and
each of the via conductors is located on the outer periphery of the internal dielectric so as to fill a space between the adjacent inner conductors and is in contact with both of the adjacent inner conductors.

2. The printed wiring board according to claim 1, wherein
the outer periphery of the inner dielectric portion and the inner periphery of the outer dielectric portion are rectangular, and
each of the via conductors is located at a corner of the outer periphery of the inner dielectric portion and a corner of the outer periphery of the outer dielectric portion.

3. The printed wiring board according to claim 1 or 2, further comprising
multiple outer conductors located on the inner periphery of the outer dielectric portion and arranged with a gap between adjacent outer conductors of the multiple outer conductors in the peripheral direction on the inner periphery of the outer dielectric portion, wherein
each of the via conductors is located between adjacent outer conductors of the outer conductors on the inner periphery of the outer dielectric portion and connected to the adjacent outer conductors.

4. The printed wiring board according to claim 3, further comprising
multiple filling resin portions located between the outer periphery of the inner dielectric portion and the inner periphery of the outer dielectric portion and between the inner conductors and the outer conductors.

5. The printed wiring board according to claim 4, wherein
each of the via conductors comprises a conductive portion extending from the outer periphery of the inner dielectric portion to the inner periphery of the outer dielectric portion, electrically connecting the inner conductor and the outer conductor.

6. The printed wiring board according to any one of claims 1 to 5, wherein
the inner conductors are formed on the outer periphery of the inner dielectric portion throughout entire thickness of the dielectric layer from the first surface to the second surface.

7. The printed wiring board according to any one of claims 1 to 6, wherein
each of the inner conductors comprises a conductor protrusion protruding in a direction from the inner dielectric portion toward the outer dielectric portion and connected to a corresponding one of the via conductors.

8. The printed wiring board according to claim 3 or 4, wherein
each of the outer conductors comprises a conductor protrusion protruding in a direction from the outer dielectric portion toward the inner dielectric portion and connected to a corresponding one of the via conductors.

9. The printed wiring board according to any one of claims 1 to 8, further comprising:
a first conductor layer stacked on the first surface, grounded, and comprising a first port at a position overlapping the inner dielectric portion; and
a second conductor layer stacked on the second surface, grounded, and comprising a second port at a position overlapping the inner dielectric portion, wherein
the via conductors are connected to the first conductor layer and the second conductor layer, and
the inner dielectric portion and the outer dielectric portion have a same dielectric property.

10. The printed wiring board according to any one of claims 1 to 9, wherein
the via conductors do not protrude from the outer periphery of the inner dielectric portion toward a center of the inner dielectric portion, and
the closed region is rectangular.

11. The printed wiring board according to claim 9, further comprising
a build-up layer stacked on the first conductor layer, wherein
the build-up layer comprises:
a second dielectric layer stacked on the first conductor layer; and
a surface conductor layer stacked on the second dielectric layer, and
the surface conductor layer comprises a signal line extending to a position overlapping the first port.

12. A method for manufacturing a printed wiring board, comprising:
forming multiple slots in a dielectric layer comprising first and second surfaces facing away from each other and extending in surface directions, the multiple slots surrounding a closed region, extending in the surface directions, of the dielectric layer and extending through the dielectric layer from the first surface to the second surface around the closed region;
forming metal plating layers on inner surfaces of the slots;
filling spaces on inner sides of the metal plating layers in the slots with resin, and curing the resin;
forming holes extending from the first surface to the second surface, each hole located in a portion between adjacent slots of the slots in the dielectric layer; and
forming via conductors on inner surfaces of the holes and electrically connecting the via conductors to the metal plating layers.
